(19) Europäisches Patentamt
European Patent Office
Office européen des brevets

(11) **EP 2 817 650 B1**

(12) **EUROPÄISCHE PATENTSCHRIFT**

(45) Veröffentlichungstag und Bekanntmachung des Hinweises auf die Patenterteilung:
**26.12.2018  Patentblatt 2018/52**

(21) Anmeldenummer: **13709335.7**

(22) Anmeldetag: **20.02.2013**

(51) Int Cl.:
**G01R 35/00** *(2006.01)*    **G01R 27/28** *(2006.01)*
**G01D 21/00** *(2006.01)*

(86) Internationale Anmeldenummer:
**PCT/EP2013/053337**

(87) Internationale Veröffentlichungsnummer:
**WO 2013/124295 (29.08.2013 Gazette 2013/35)**

(54) **SYSTEM UND VERFAHREN ZUR KALIBRIERUNG EINER MESSANORDNUNG UND ZUR CHARAKTERISIERUNG EINER MESSHALTERUNG**

SYSTEM AND METHOD FOR CALIBRATING A MEASURING DEVICE AND FOR CHARACTERIZING A MEASURING FIXTURE

SYSTÈME ET PROCÉDÉ DE CALIBRATION D'UN DISPOSITIF DE MESURE ET DE CARACTÉRISATION D'UN MONTAGE DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.02.2012   DE 102012003285**
**06.02.2013   DE 102013201914**

(43) Veröffentlichungstag der Anmeldung:
**31.12.2014   Patentblatt 2015/01**

(73) Patentinhaber: **Rohde & Schwarz GmbH & Co. KG**
**81671 München (DE)**

(72) Erfinder:
• **SCHMIDT, Lorenz-Peter**
**91093 Heßdorf (DE)**
• **SCHRAMM, Marcus**
**96129 Strullendorf (DE)**
• **HROBAK, Michael**
**10249 Berlin (DE)**
• **SCHÜR, Jan**
**91094 Langensendelbach (DE)**

(74) Vertreter: **Körfer, Thomas et al**
**Mitscherlich PartmbB**
**Patent- und Rechtsanwälte**
**Sonnenstrasse 33**
**80331 München (DE)**

(56) Entgegenhaltungen:
**EP-A1- 2 241 899**

• **YUN ZHANG ET AL: "Measurement of a reciprocal four-port transmission line structure using the 16-term error model", MICROWAVE AND OPTICAL TECHNOLOGY LETTERS, Bd. 49, Nr. 7, Juli 2007 (2007-07), Seiten 1511-1515, XP055066964, ISSN: 0895-2477, DOI: 10.1002/mop.22498**
• **MARCUS SCHRAMM ET AL: "MOS-16: A new method for in-fixture calibration and fixture characterization", MICROWAVE MEASUREMENT CONFERENCE (ARFTG), 2011 77TH ARFTG, IEEE, 10. Juni 2011 (2011-06-10), Seiten 1-7, XP031972673, DOI: 10.1109/ARFTG77.2011.6034560 ISBN: 978-1-61284-959-1 in der Anmeldung erwähnt**

EP 2 817 650 B1

## Beschreibung

Die Erfindung betrifft ein System und ein Verfahren zur Kalibrierung einer Messanordnung und zur Charakterisierung einer Messhalterung.

Werden die Streuparameter eines Messobjekts mithilfe eines Netzwerkanalysators vermessen, so sind die gemessenen Streuparameter des Messobjekts durch Nichtidealitäten des Netzwerkanalysators, der Messleitungen und der Messhalterung, in der das Messobjekt fixiert ist, beeinflusst und entsprechen nicht den tatsächlichen Streuparametern des Messobjekts. Mittels einer Kalibrierung sind die durch die Nichtidealitäten des Netzwerkanalysators, der Messleitungen und der Messhalterung hervorgerufenen Systemfehler zu bestimmen. Mit den bestimmten Systemfehlern werden im Messbetrieb die vom Netzwerkanalysator gemessenen Streuparameter in die tatsächlichen Streuparameter umgerechnet.

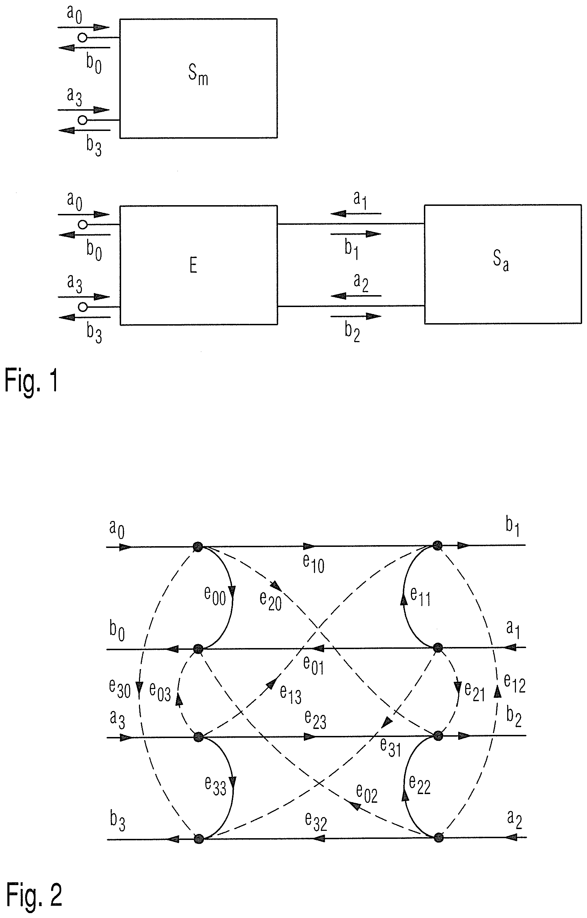

Aus Fig. 1 geht ein die Systemfehler berücksichtigendes Messmodell hervor. Der reale Netzwerkanalysator bestimmt in einer nicht-idealen Messanordnung die gemessenen Streuparameter $S_m$ des Messobjekts anhand der jeweils erfassten hinlaufenden Wellengrößen $a_0$ und $a_3$ und der erfassten zurücklaufenden Wellengrößen $b_0$ und $b_3$, die jeweils von Systemfehlern verunreinigt sind. Die tatsächlichen Streuparameter $S_a$ des Messobjekts lassen sich anhand der zum Messobjekt jeweils hinlaufenden Wellengrößen $a_1$ und $a_2$ und der zum Messobjekt jeweils zurücklaufenden Wellengrößen $b_1$ und $b_2$ bestimmen, die jeweils nicht von Systemfehlern verunreinigt sind und nur in einer idealen Messanordnung ermittelbar wären. Die zum Messobjekt jeweils hinlaufenden Wellengrößen $a_1$ und $a_2$ und die zum Messobjekt jeweils zurücklaufenden Wellengrößen $b_1$ und $b_2$ weisen eine konträre Richtung zu den in Fig. 1 jeweils dargestellten Wellengrößen $a_1$, $a_2$, $b_1$ und $b_2$ auf, die zu den die Systemfehler E enthaltenden Fehlertoren in Bezug gesetzt sind. Der reale Netzwerkanalysator ermittelt die von Systemfehlern bereinigten Wellengrößen $a_1$, $a_2$, $b_1$ und $b_2$ aus den erfassten und mit Systemfehlern verunreinigten Wellengrößen $a_0$, $a_3$, $b_0$ und $b_3$ mittels Transformation mit den vorab bestimmten Systemfehlern E. Diese Transformation wird als Ent-Einbettung (engl.: de-embedding) bezeichnet.

Muss in den Messaufbau ein Übersprechen bei der Systemfehlerbestimmung berücksichtigt werden, so ist das 16-Term-Fehlermodell vorteilhaft anzuwenden.

Gleichung (1) stellt den zugehörigen mathematischen Zusammenhang zwischen den einzelnen Elementen der Systemfehlermatrix E und den einzelnen hinlaufenden Wellengrößen $a_0$, $a_1$, $a_2$ und $a_3$ bzw. den jeweiligen zurücklaufenden Wellengrößen $b_0$, $b_1$, $b_2$ und $b_3$ dar. Es enthält insgesamt 16 Elemente, woraus sich der Name ableitet, und ist mit seinen 16 Elementen im Signalflussdiagramm der Fig. 2 dargestellt.

$$\begin{bmatrix} b_0 \\ b_3 \\ b_1 \\ b_2 \end{bmatrix} = \begin{bmatrix} e_{00} & e_{03} & e_{01} & e_{02} \\ e_{30} & e_{33} & e_{31} & e_{32} \\ e_{10} & e_{13} & e_{11} & e_{12} \\ e_{20} & e_{23} & e_{21} & e_{22} \end{bmatrix} \cdot \begin{bmatrix} a_0 \\ a_3 \\ a_1 \\ a_2 \end{bmatrix} = \begin{bmatrix} E \end{bmatrix} \cdot \begin{bmatrix} a_0 \\ a_3 \\ a_1 \\ a_2 \end{bmatrix} = \begin{bmatrix} E_1 & E_2 \\ E_3 & E_4 \end{bmatrix} \cdot \begin{bmatrix} a_0 \\ a_3 \\ a_1 \\ a_2 \end{bmatrix} \qquad (1)$$

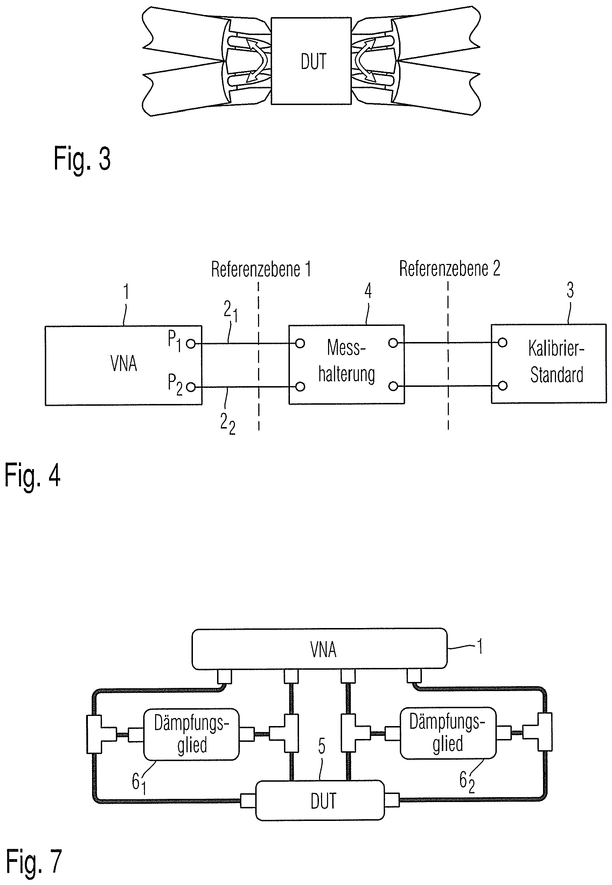

Die Systemfehlermatrix E beschreibt die durch das Messgerät, den Messaufbau und die Messhalterung verursachte Beeinflussung der am Messgerät tatsächlich anliegenden Wellengrößen $a_1$, $a_2$, $b_1$ und $b_2$, die zu den dem Messgerät zugänglichen Messgrößen $a_0$, $a_3$, $b_0$ und $b_3$ führt. Die Nebendiagonalelemente der Untermatrizen $E_1$ bis $E_4$ beschreiben in dieser Form das im Messsystem enthaltene Übersprechen. Das Übersprechen ergibt sich in der Praxis beispielsweise aus mangelnder Isolation der Signalpfade des vektoriellen Netzwerkanalysators, mangelnder Schirmung der Hochfrequenzmessleitungen und mangelnder Schirmung der Messhalterung, wie in Fig. 3 am Beispiel einer Messspitze schematisch angedeutet ist.

Eine zur Gleichung (1) äquivalente Darstellung für den Zusammenhang zwischen den einzelnen hinlaufenden Wellengrößen $a_0$, $a_1$, $a_2$ und $a_3$ bzw. den jeweiligen zurücklaufenden Wellengrößen $b_0$, $b_1$, $b_2$ und $b_3$ geht aus Gleichung (2) hervor, in der an die Stelle von Fehlertermen E Fehlerterme T treten.

$$\begin{bmatrix} b_0 \\ b_3 \\ a_0 \\ a_3 \end{bmatrix} = \begin{bmatrix} t_0 & t_1 & t_4 & t_5 \\ t_2 & t_3 & t_6 & t_7 \\ t_8 & t_9 & t_{12} & t_{13} \\ t_{10} & t_{11} & t_{14} & t_{15} \end{bmatrix} \cdot \begin{bmatrix} a_1 \\ a_2 \\ b_1 \\ b_2 \end{bmatrix} = \begin{bmatrix} T \end{bmatrix} \cdot \begin{bmatrix} a_1 \\ a_2 \\ b_1 \\ b_2 \end{bmatrix} = \begin{bmatrix} T_1 & T_2 \\ T_3 & T_4 \end{bmatrix} \cdot \begin{bmatrix} a_1 \\ a_2 \\ b_1 \\ b_2 \end{bmatrix} \qquad (2)$$

In Anlehnung an Silvonen K. "New Five-Standard Calibration Procedures for Network Analyzers and Wafer Probes", ISBN 951-22-1989-1, 24. Juli 1998, liefert Gleichung (3) einen Zusammenhang zwischen den gemessenen Streuparametern $S_m$ des Messobjekts, den tatsächlichen Streuparametern $S_a$ des Messobjekts und den einzelnen Untermatrizen der Systemfehlermatrix E und Gleichung (4) einen entsprechenden Zusammenhang zwischen den gemessenen Streuparametern $S_m$ des Messobjekts, den tatsächlichen Streuparametern $S_a$ des Messobjekts und den einzelnen Untermatrizen der Systemfehlermatrix T. Während Gleichung (3) zu einem nicht-linearen Gleichungssystem zur Bestimmung der Systemfehler E führt, kann aus Gleichung (4) ein lineares Gleichungssystem zur Bestimmung der Systemfehler T abgeleitet werden. Diese Darstellung der Systemfehler mit der Matrix T wird deshalb als linear-in-T-Systemfehler - wie auch im Folgenden - bezeichnet und ist in der Praxis eine übliche Form zur Darstellung von Systemfehlern bei Verwendung eines 16-Term-Fehlermodells.

$$S_m = E_1 + E_2 \cdot (I - S_a \cdot E_4)^{-1} \cdot S_a \cdot E_3 \qquad (3)$$

$$S_m \cdot (T_3 \cdot S_a + T_4) = (T_1 \cdot S_a + T_2) \qquad (4)$$

Schramm M. et al. "MOS-16: A New Method for In-Fixture Calibration and Fixture Characterization" in Proceeedings of the ARFTG, Baltimore, USA, Juni 2010, beschreibt ein 16-Term-Kalibrierverfahren. Das 16-Term-Kalibrierverfahren erfordert neben der Reziprozität der Messhalterung nachteilig jeweils identische Reflexionskoeffizienten auf der Eingangs- und Ausgangsseite der Messhalterung.

Aus Silvonen K. "LMR 16 - A Self-Calibration Procedure for a Leaky Network Analyzer" in IEEE Transactions on Microwave Theory and Techniques, Vol. 45, No. 7, Juli 1997, Seiten 1041 bis 1049, ist ein anderes 16-Term-Kalibrierverfahren bekannt. Neben vier transmissionslosen Kalibrierstandards verwendet das Kalibrierverfahren zusätzlich einen fünften transmissionsbehafteten Kalibrierstandard. Das Transmissionsverhalten des fünften Kalibrierstandards muss hierzu über dem gesamten Messfrequenzbereich exakt bekannt sein. Diese Anforderung ist bei Verwendung einer Messhalterung unter Umständen technisch entweder sehr aufwendig oder überhaupt nicht möglich.

Auch Yun Zhang; Kimmo Silvonen; Ning H Zhu: 'Measurement of a reciprocal four-port transmission line structure using the 16-term error model'; Microwave and Optical Technology Letters, Vol. 49, Nr. 7, S. 1511-1515, 2007, offenbart ein 16-Term-Kalibrierverfahren.

Aufgabe der Erfindung ist es deshalb, ein Verfahren zur Kalibrierung und ein Verfahren zur Charakterisierung sowie jeweils ein zugehöriges System zu schaffen, das die Nachteile der obig genannten Veröffentlichungen überwindet.

Die Aufgabe wird durch ein Verfahren zur Kalibrierung einer Messanordnung, bevorzugt anhand eines 16-Term-Fehlermodells, mit den Merkmalen des Patentanspruchs 1, durch ein zugehöriges System zur Kalibrierung einer Messanordnung, bevorzugt eines 16-Term-Fehlermodells, mit den Merkmalen des Patentanspruchs 18, durch ein Verfahren zur Charakterisierung einer mit einem Netzwerkanalysator verbundenen Messhalterung mit den Merkmalen des Patentanspruchs 6 und durch ein zugehöriges System zur Charakterisierung einer mit einem Netzwerkanalysator verbundenen Messhalterung mit den Merkmalen des Patentanspruchs 19 gelöst. Vorteilhafte technische Weiterentwicklungen sind in den jeweils abhängigen Patentansprüchen aufgeführt.

Sowohl für den Fall der Kalibrierung einer Messanordnung mithilfe von Kalibrierstandards als auch für den Fall der Charakterisierung einer Messhalterung, in der ein Kalibrierstandard oder ein Messobjekt fixiert ist, werden die mit dem Netzwerkanalysator gemessenen Transmissions- und Reflexionskoeffizienten von vorzugsweise vier transmissionslosen Kalibrierstandards und von einem transmissionsbehafteten Kalibrierstandard zusammen mit den tatsächlichen, als bekannt vorausgesetzten Eigenschaften der Kalibrierstandards in eine Gleichungssysteme eingefügt, die eine Bestimmung von 15 linear-in-T-Parameter im Falle der Kalibrierung und die Berechnung aller Streuparameter einer Messhalterung im Fall einer Charakterisierung erlauben.

Aus der Struktur des sich für das 16-Term-Fehlermodell ergebenden Gleichungssystems bedingt sich ein maximaler Rang von 15. Somit kann der Wert eines der 16 linear-in-T-Systemfehler frei gewählt werden und der somit gewählte 16. linear-in-T-Systemfehler als Normierungsgröße zur Normierung der übrigen 15 linear-in-T-Systemfehler herangezogen werden. Werden lediglich die bekannten transmissionslosen Kalibrierstandards verwendet, weist das entstehende Gleichungssystem einen maximalen Rang von 14 auf. Durch eine vorerst freie Wahl eines weiteren Parameters kann eine Lösung des Gleichungssystems ohne Verwendung des transmissionsbehafteten Kalibrierstandards gefunden werden. Zur Lösung des linearen Gleichungssystems können gängige numerische Verfahren wie beispielsweise das Newton-Raphson- oder das Gauss-Jordan-Verfahren Verwendung finden.

Um eine Kalibrierung der Messanordnung durchführen zu können, werden insgesamt 15 linear-in-T-Systemfehler benötigt, die eine Abhängigkeit einzig von einem 16. linear-in-T-Systemfehler aufweisen. Bei der Charakterisierung der Messhalterung werden alle 16 linear-in-T-Systemfehler bestimmt.

Wie noch weiter unten im Detail gezeigt wird, kann vorteilhaft bei Verwendung eines transmissionsbehafteten, reziproken Kalibrierstandards einer der beiden frei festgelegten linear-in-T-Systemfehler - im Folgenden als zweiter linear-in-T-Systemfehler bezeichnet - erfindungsgemäß in Abhängigkeit des jeweils anderen frei festgelegten linear-in-T-Systemparameters - im Folgenden als erster linear-in-T-Systemfehler bezeichnet - bestimmt werden. Die restlichen 14 mittels Lösen des linearen Gleichungssystems bestimmten linear-in-T-Systemfehler werden schließlich entweder mit dem frei festgelegten ersten linear-in-T-Systemfehler oder mit einem vom ersten linear-in-T-Systemfehler abhängigen korrekten zweiten linear-in-T-Systemfehler gewichtet.

Um die Abhängigkeit des korrekten zweiten linear-in-T-Systemfehlers vom ersten linear-in-T-Systemfehler zu ermitteln, wird im Fall der Kalibrierung einer Messanordnung bevorzugt der fünfte transmissionsbehaftete und reziproke Kalibrierstandard verwendet.

Der Wert des korrekten zweiten linear-in-T-Systemfehlers erfolgt hierbei vorzugsweise unter Ausnutzung der Reziprozitätsbedingung des transmissionsbehafteten und reziproken Kalibrierstandards.

Hierzu werden die gemessenen Transmissionskoeffizienten des fünften transmissionsbehafteten Kalibrierstandards mit den 14 bestimmten linear-in-T-Systemfehlern, dem ersten und zweiten frei festgelegten linear-in-T-Systemfehler zu transformierten Transmissionskoeffizienten des fünften transmissionsbehafteten Kalibrierstandards überführt.

Ein beim Wert des korrekten zweiten linear-in-T-Systemfehlers zusätzlich zu berücksichtigendes Vorzeichen lässt sich bevorzugt bei Kenntnis der bekannten elektrischen Eigenschaften, weiter bevorzugt der bekannten elektrischen Länge, des fünften transmissionsbehafteten und reziproken Kalibrierstandards mittels Plausibilitätsbetrachtung zwischen der elektrische Länge und den transformierten Transmissionskoeffizienten des fünften Kalibrierstandards ermitteln. Aufgrund von Plausibilitätsbetrachtungen müssen die tatsächlichen Transmissionskoeffizienten des fünften transmissionsbehafteten und reziproken Kalibrierstandards im Gegensatz zum Stand der Technik vorteilhaft nicht exakt bekannt sein.

In einer bevorzugten erfindungsgemäßen Charakterisierung einer mit einem Netzwerkanalysator verbundenen Messhalterung wird die Tatsache ausgenutzt, dass die das Transmissions-, das Reflexions- und das Übersprechverhalten der Messhalterung charakterisierenden Parameter einzelnen Systemfehlern einer Systemfehlermatrix E entsprechen, die durch Transformation von korrespondierenden linear-in-T-Systemfehlern entstehen, welche aus den tatsächlichen und gemessenen Streuparametern von verschiedenen nacheinander in der Messhalterung fixierten Kalibrierstandards ableitbar sind.

Hierzu werden vorzugsweise zuerst die gemessenen und tatsächlichen Streuparameter der in der Messhalterung fixierten Kalibrierstandards in eine Matrix eingefügt, die zusammen mit den zu ermittelnden linear-in-T-Systemfehlern ein lineares Gleichungssystem bildet. Mittels freier Wahl eines ersten und zweiten linear-in-T-Systemfehlers können die restlichen 14 linear-in-T-Systemfehler in Abhängigkeit des ersten und zweiten linear-in-T-Systemfehlers durch Lösen des linearen Gleichungssystems bestimmt werden. Die bestimmten linear-in-T-Systemfehler können in gängiger Weise in korrespondierende Systemfehler einer Systemfehlermatrix E des 16-Term-Fehlermodells transformiert werden.

Bei der erfindungsgemäßen Charakterisierung einer mit einem Netzwerkanalysator verbundenen Messhalterung lassen sich ein korrekter erster linear-in-T-Systemfehler und ein korrekter zweiter linear-in-T-Systemfehler ermitteln. Auf diese Weise lässt sich die Normierung zum ersten linear-in-T-Systemfehler aufheben, so dass die Streuparameter der Messhalterung nach Betrag und Phase als Elemente der Systemfehlermatrix E vorliegen.

Die Messhalterung muss hierzu nur hinsichtlich der Transmission in ihren beiden Transmissionspfaden reziprok sein. Im Gegensatz zur Messanordnung in Schramm M. et al. "MOS-16: A New Method for In-Fixture Calibration and Fixture Characterization" in Proceedings of the ARFTG, Baltimore, USA, Juni 2010, muss sie vorteilhaft kein identisches Reflexionsverhalten an den beiden Eingängen oder an den beiden Ausgängen aufweisen.

In einer ersten bevorzugten Ausführungsform der erfindungsgemäßen Charakterisierung einer mit einem Netzwerkanalysator verbundenen Messhalterung wird der Wert des korrekten ersten linear-in-T-Systemfehlers und der Wert des korrekten zweiten linear-in-T-Systemfehlers jeweils unter Ausnutzung der Reziprozitätsbedingung der reziproken Messhalterung und des in der reziproken Messhalterung fixierten reziproken und transmissionsbehafteten Kalibrierstandards anhand von zwei zueinander reziproken und zu jeweils einem Transmissionspfad der Messhalterung gehörigen Transmissionskoeffizienten in der Systemfehlermatrix E bestimmt. Da diese Transmissionskoeffizienten der beiden Transmissionspfade der Messhalterung in der Systemfehlermatrix E entweder eine Abhängigkeit vom ersten oder vom zweiten linear-in-T-Systemfehler aufweisen, lassen sich der erste und zweite linear-in-T-Systemfehler unabhängig voneinander ermitteln.

Ein beim Wert des korrekten ersten linear-in-T-Systemfehlers zusätzlich zu berücksichtigendes Vorzeichen und ein beim Wert des korrekten zweiten linear-in-T-Systemfehlers zusätzlich zu berücksichtigendes Vorzeichen lassen sich in einer ersten bevorzugten Ausführungsform der erfindungsgemäßen Charakterisierung einer mit einem Netzwerkanalysator verbundenen Messhalterung jeweils bei Kenntnis der bekannten elektrischen Eigenschaften, bevorzugt der bekannten elektrischen Länge, von einem der Transmissionspfade der Messhalterung mittels Plausibilitätsbetrachtung zwischen der elektrische Länge und den zueinander reziproken Transmissionskoeffizienten in der ermittelten Systemfehlermatrix E eines der beiden Transmissionspfade der Messhalterung ermitteln. Die Länge der Messhalterung muss hierbei vorteilhaft nicht genau bekannt sein, bzw. nur mit einer Phasenkenntnis $\pm 90°$.

In einer zweiten bevorzugten Ausführungsform der erfindungsgemäßen Charakterisierung einer mit einem Netzwerkanalysator verbundenen Messhalterung werden zuerst der Wert des Verhältnisses zwischen erstem und zweitem linear-in-T-Systemfehler und das beim Wert des Verhältnisses zwischen erstem und zweitem linear-in-T-Systemfehler zusätzlich zu berücksichtigende Vorzeichen mittels eines in der Messhalterung fixierten fünften transmissionsbehafteten und reziproken Kalibrierstandards bestimmt.

Der Wert des Verhältnisses zwischen erstem und zweitem linear-in-T-Systemfehler erfolgt vorzugsweise äquivalent wie bei der Kalibrierung einer Messanordnung unter Ausnutzung der Reziprozitätsbedingung eines fünften transmissionsbehafteten und reziproken Kalibrierstandards.

Hierzu werden transformierte Transmissionskoeffizienten des fünften transmissionsbehafteten und reziproken Kalibrierstandards mittels Transformation der gemessenen Transmissionskoeffizienten des in der Messhalterung fixierten fünften transmissionsbehafteten Kalibrierstandards mit den 14 bestimmten linear-in-T-Systemfehlern und dem ersten und zweiten linear-in-t-Systemfehler bestimmt.

Das beim Wert des Verhältnisses zwischen erstem und zweitem linear-in-T-Systemfehler zu berücksichtigende Vorzeichen lässt sich äquivalent wie bei der Kalibrierung einer Messanordnung bei Kenntnis der bekannten elektrischen Eigenschaften, bevorzugt der bekannten elektrischen Länge, des fünften transmissionsbehafteten und reziproken Kalibrierstandards mittels Plausibilitätsbetrachtung zwischen der elektrischen Länge und den transformierten Transmissionskoeffizienten des fünften transmissionsbehafteten und reziproken Kalibrierstandards, der in der Messhalterung fixiert ist, ermitteln.

Daraufhin wird vorzugsweise entweder der Wert des korrekten ersten linear-in-T-Systemfehlers oder der Wert des korrekten zweiten linear-in-T-Systemfehlers ermittelt. Dieser ergibt sich äquivalent wie in der ersten Ausführungsform der erfindungsgemäßen Charakterisierung einer mit einem Netzwerkanalysator verbundenen Messhalterung unter Ausnutzung der Reziprozitätsbedingung der reziproken Messhalterung und des in der reziproken Messhalterung fixierten reziproken und transmissionsbehafteten Kalibrierstandards anhand von zwei zueinander reziproken und zu einem Transmissionspfad der Messhalterung gehörigen Transmissionskoeffizienten in der Systemfehlermatrix E bei Fixierung eines fünften transmissionsbehafteten und reziproken Kalibrierstandards in der Messhalterung.

Anschließend wird das beim Wert desjenigen korrekten linear-in-T-Systemfehlers - korrekter erster oder korrekter zweiter linear-in-T-Systemfehler - zusätzlich zu berücksichtigende Vorzeichen bestimmt, dessen Wert zuvor berechnet wurde. Die Ermittlung des beim Wert des korrekten ersten oder korrekten zweiten linear-in-T-Systemfehlers zusätzlich zu berücksichtigende Vorzeichen ergibt sich äquivalent wie in der ersten Ausführungsform der erfindungsgemäßen Charakterisierung einer mit einem Netzwerkanalysator verbundenen Messhalterung bei Kenntnis der bekannten elektrischen Eigenschaften, bevorzugt der bekannten elektrischen Länge, von einem der Transmissionspfade der Messhalterung mittels Plausibilitätsbetrachtung zwischen der elektrischen Länge und den beiden zueinander reziproken Transmissionskoeffizienten des jeweiligen Transmissionspfades der Messhalterung in der Systemfehlermatrix E bei Fixierung des fünften transmissionsbehafteten und reziproken Kalibrierstandards in der Messhalterung. Die elektrische Länge des Transmissionspfades muss hierbei vorteilhaft nicht genau bekannt sein.

Der Wert und das beim Wert zusätzlich zu berücksichtigende Vorzeichen des jeweils anderen korrekten linear-in-T-Systemfehlers - d.h. des korrekten ersten oder des korrekten zweiten linear-in-T-Systemfehlers - ergibt sich aus dem zuerst ermittelten korrekten linear-in-T-Systemfehler und dem ermittelten Verhältnis zwischen dem ersten und zweiten linear-in-T-Systemfehler.

Abschließend werden beim erfindungsgemäßen Verfahren zur erfindungsgemäßen Charakterisierung einer mit einem Netzwerkanalysator verbundenen Messhalterung die Transmissions-, Reflexions- und Übersprechparameter der Messhalterung aus den zugehörigen Systemfehlern der Systemfehlermatrix E bevorzugt ermittelt, indem die aus dem linearen Gleichungssystem ermittelten linear-in-T-Systemfehler der Systemfehlermatrix T jeweils mit dem hinsichtlich Wert und beim Wert zusätzlich zu berücksichtigenden Vorzeichen korrekt ermittelten ersten oder zweiten linear-in-T-Systemfehler gewichtet werden und anschließend in die Systemfehlermatrix E überführt werden.

Die einzelnen Ausführungsformen des erfindungsgemäßen Verfahrens und des erfindungsgemäßen Systems zur Kalibrierung einer Messanordnung und des erfindungsgemäßen Verfahren und des erfindungsgemäßen Systems zur Charakterisierung einer mit einem Netzwerkanalysator verbundenen Messhalterung werden im Folgenden beispielhaft anhand eines 16-Term-Fehlermodells anhand der Zeichnung im Detail erläutert. Die Figuren der Zeichnung zeigen:

Fig. 1    ein Blockdiagramm eines üblichen Messmodells,

Fig. 2    ein Signalflussgraf eines 16-Term-Fehlermodells,

Fig. 3    eine Darstellung von Übersprechen in Masse-Signal-Masse-Signal-Masse-Messleitungsanschlüssen, die mit einem 4-Tor-Messobjekt verbunden sind,

Fig. 4    ein Blockdiagramm eines erfindungsgemäßen Systems zur Kalibrierung einer Messanordnung anhand eines 16-Term-Fehlermodells oder eines erfindungsgemäßen Systems zur Charakterisierung einer mit einem Netzwerkanalysator verbundenen Messhalterung,

Fig. 5    ein Flussdiagramm eines erfindungsgemäßen Verfahrens zur Kalibrierung einer Messanordnung anhand eines 16-Term-Fehlermodells,

Fig. 6A    ein Flussdiagramm einer ersten Ausführungsform des erfindungsgemäßen Verfahrens zur Charakterisierung einer mit einem Netzwerkanalysator verbundenen Messhalterung,

Fig. 6B    ein Flussdiagramm einer zweiten Ausführungsform des erfindungsgemäßen Verfahren zur Charakterisierung einer mit einem Netzwerkanalysator verbundenen Messhalterung,

Fig. 7    ein Blockdiagramm einer Messanordnung zur Verifizierung des erfindungsgemäßen Verfahrens,

Fig. 8A    ein Frequenzdiagramm der durch das erfindungsgemäße Verfahren jeweils gemessenen Transmissionskoeffizienten von mehreren Messobjekten mit jeweils unterschiedlichen Transmissionseigenschaften,

Fig. 8B    ein Frequenzdiagramm der durch das TOM-X-Verfahren jeweils gemessenen Transmissionskoeffizienten von mehreren Messobjekten mit jeweils unterschiedlichen Transmissionseigenschaften,

Fig. 8C    ein Frequenzdiagramm der durch das LSQ-16-Term-Verfahren jeweils gemessenen Transmissionskoeffizienten von mehreren Messobjekten mit jeweils unterschiedlichen Transmissionseigenschaften,

Fig. 9A    ein Frequenzdiagramm der durch das erfindungsgemäße Verfahren jeweils gemessenen Reflexion von mehreren Messobjekten mit jeweils unterschiedlichen Reflexionseigenschaften,

Fig. 9B    ein Frequenzdiagramm der durch das TOM-X-Verfahren jeweils gemessenen Reflexion von mehreren Messobjekten mit jeweils unterschiedlichen Reflexionseigenschaften,

Fig. 9C    ein Frequenzdiagramm der durch das LSQ-16-Term-Verfahren jeweils gemessenen Reflexion von mehreren Messobjekten mit jeweils unterschiedliches Reflexionseigenschaften und

Fig. 10    eine Tabelle mit beispielhaften Kombinationen von Kalibrierstandards zur erfindungsgemäßen 16-Term-Kalibrierung.

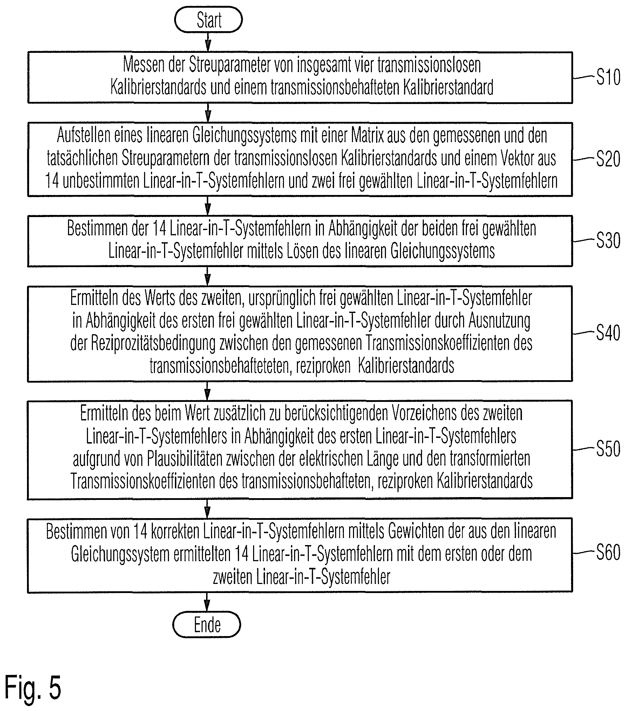

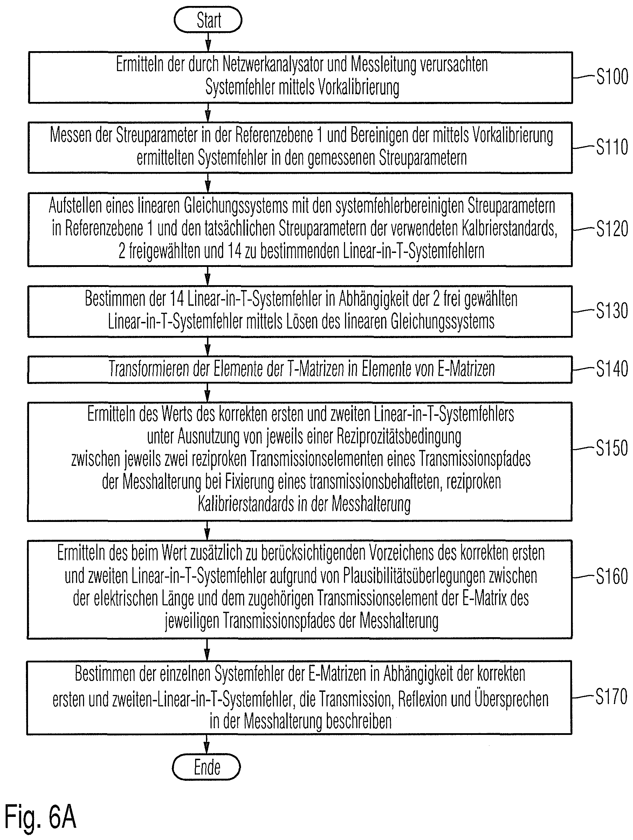

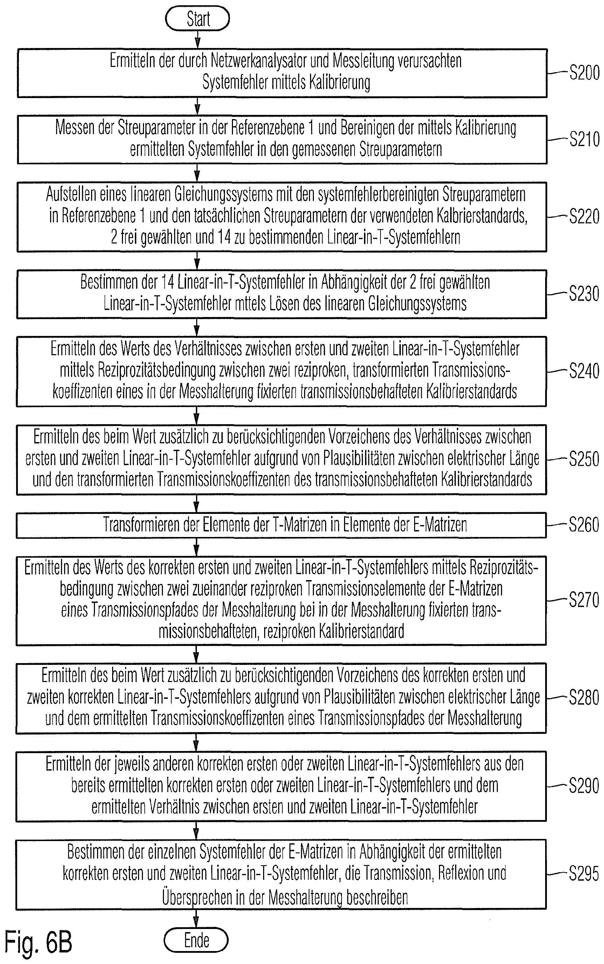

Bevor die technischen Realisierungen der Erfindung anhand des Blockdiagramms in Fig. 4 und anhand der Flussdiagramme in den Figuren 5, 6A und 6B im Detail erläutert werden, werden im Folgenden ausgehend von den in der Einleitung bereits vorgestellten mathematischen Beziehungen die für das Verständnis der Erfindung erforderlichen mathematischen Grundlagen hergeleitet.

Löst man die mathematische Beziehung in Gleichung (4) zwischen den in Gleichung (5A) mathematisch beschriebenen tatsächlichen Streuparametern $S_a$ des Messobjekts, den in Gleichung (5B) mathematisch beschriebenen gemessenen Streuparametern $S_m$ des Messobjekts und den in Gleichung (2) mathematisch beschriebenen Koeffizienten der linear-in-T-Systemfehlermatrix $T$ auf, so erhält man die Beziehung in Gleichung (6A) bzw. die verkürzte Version in Gleichung (6B).

$$S_a = \begin{bmatrix} S_{a11} & S_{a12} \\ S_{a21} & S_{a22} \end{bmatrix} \qquad\qquad (5A)$$

$$S_m = \begin{bmatrix} S_{m11} & S_{m12} \\ S_{m21} & S_{m22} \end{bmatrix} \qquad\qquad (5B)$$

$$\begin{bmatrix} S_{a11} & S_{a21} & 0 & 0 & 1 & 0 & 0 & 0 & -S_{m11}\cdot S_{a11} & -S_{m11}\cdot S_{a21} \\ S_{a12} & S_{a22} & 0 & 0 & 0 & 1 & 0 & 0 & -S_{m11}\cdot S_{a12} & -S_{m11}\cdot S_{a22} \\ 0 & 0 & S_{a11} & S_{a21} & 0 & 0 & 1 & 0 & -S_{m21}\cdot S_{a11} & -S_{m21}\cdot S_{a21} \\ 0 & 0 & S_{a12} & S_{a22} & 0 & 0 & 0 & 1 & -S_{m21}\cdot S_{a11} & -S_{m21}\cdot S_{a22} \end{bmatrix}$$

$$\begin{bmatrix} -S_{m12}\cdot S_{a11} & -S_{m12}\cdot S_{a21} & -S_{m11} & 0 & -S_{m12} & 0 \\ -S_{m12}\cdot S_{a12} & -S_{m12}\cdot S_{a22} & 0 & -S_{m11} & 0 & -S_{m12} \\ -S_{m22}\cdot S_{a11} & -S_{m22}\cdot S_{a21} & -S_{m21} & 0 & -S_{m22} & 0 \\ -S_{m22}\cdot S_{a12} & -S_{m22}\cdot S_{a22} & 0 & -S_{m21} & 0 & -S_{m22} \end{bmatrix} \cdot \begin{bmatrix} t_0 \\ t_1 \\ ... \\ t_{15} \end{bmatrix} = 0 \quad (6A)$$

$$A^{4\times16}\cdot t^{16x1} = 0 \quad \text{mit}$$

$$t = \begin{pmatrix} t_0 & t_1 & t_2 & t_3 & t_4 & t_5 & t_6 & t_7 & t_8 & t_9 & t_{10} & t_{11} & t_{12} & t_{13} & t_{14} & t_{15} \end{pmatrix}^T \quad (6B)$$

Zur Bestimmung der linear-in-T-Systemfehler des Vektors $t$ gemäß Gleichung (6B) werden insgesamt fünf Kalibriestandards verwendet. Hierbei handelt es sich um beispielsweise die vier transmissionslosen Kalibrierstandards *OM, SM, MS* und *SO* gemäß Gleichung (7A), (7B), (7C) und (7D) und den transmissionsbehafteten Kalibrierstandard *R* gemäß Gleichung (7E). Hierbei bedeutet *o* ein offener (engl. open) Abschluss, *s* ein kurzgeschlossener (engl. short) Abschluss und *m ein* angepasster (engl. matched) Abschluss des jeweiligen transmissionslosen Kalibrierstandards und *a* bzw. *c* jeweils ein Reflexionskoeffizient und *b* ein Transmissionskoeffizient des transmissionsbehafteten Kalibrierstandards.

$$OM = \begin{bmatrix} o & 0 \\ 0 & m \end{bmatrix} \qquad (7A)$$

$$SM = \begin{bmatrix} s & 0 \\ 0 & m \end{bmatrix} \qquad (7B)$$

$$MS = \begin{bmatrix} m & 0 \\ 0 & s \end{bmatrix} \qquad (7C)$$

$$SO = \begin{bmatrix} s & 0 \\ 0 & o \end{bmatrix} \qquad (7D)$$

$$R = \begin{pmatrix} a & b \\ b & c \end{pmatrix} \qquad (7E)$$

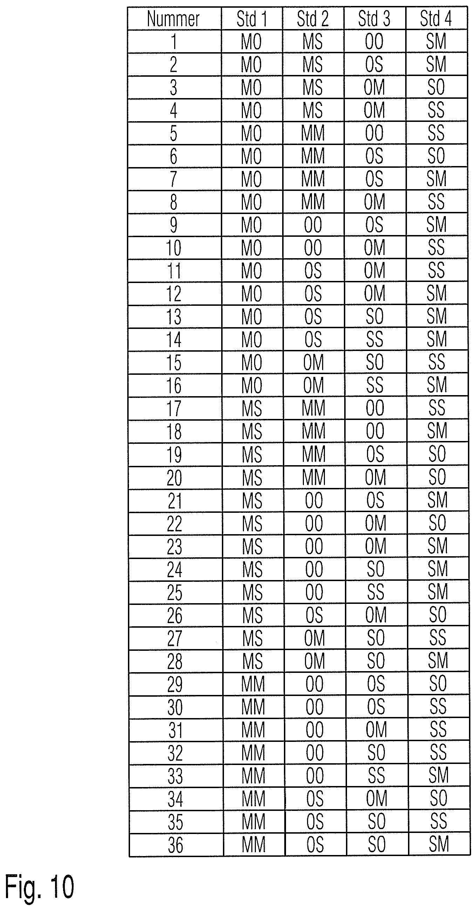

Die Tabelle in Fig. 10 gibt beispielhaft 36 verschiedene Kombinationsmöglichkeiten der vier transmissionslosen Kalibrierstandards wider, mit denen jeweils eine Kalibrierung durchgeführt werden kann.

Die 4x16-dimensionale Matrix $A^{4\times16}$ erweitert sich durch die Verwendung von fünf Kalibrierstandards anstelle von einem einzigen Kalibrierstandard zu einer 20x16 Matrix $A^{20\times16}$ gemäß Gleichung (8A). Der Rang der 20x16 dimensionalen Matrix $A^{20\times16}$ ist aufgrund ihrer inneren Struktur 15. Somit können 15 linear-in-T-Systemfehler durch einen 16.

linear-in-T-Systemfehler normiert werden. Der 16. linear-in-T-Systemfehler wird frei und unabhängig von Null gewählt. Die übrigen 15 linear-in-T-Systemfehler sind somit linear abhängig vom 16. linear-in-T-Systemfehler.

$$A^{20 \times 16} \cdot t^{16 \times 1} = 0 \tag{8A}$$

Mit den vier transmissionslosen Kalibrierstandards gemäß Gleichung (7A) bis (7D) ergibt sich eine Matrix $A^{16 \times 16}$, deren maximaler Rang aufgrund der inneren Struktur des Gleichungssystems den Wert 14 annimmt. Folglich können insgesamt 14 linear-in-T-Systemfehler des Vektors $t$ bestimmt werden. Somit muss noch ein weiterer linear-in-T-Systemfehler frei gewählt werden. Der erste frei gewählte linear-in-T-Systemfehler wird im Folgenden mit $k$, der zweite frei gewählte linear-in-T-Systemfehler mit $p$ bezeichnet. Das lineare Gleichungssystem (8A) wird damit in das lineare Gleichungssystem (8B) mit der 16x14-dimensionalen Matrix $\tilde{A}^{16 \times 14}$, den 14 zu bestimmenden linear-in-T-Systemfehlern $\tilde{t}^{14 \times 1}$, den frei gewählten ersten und zweiten linear-in-T-Systemfehlern $k$ und $p$ und den zugehörigen Vektoren $V_1^{16 \times 1}$ und $V_2^{16 \times 1}$ überführt.

$$\tilde{A}^{16 \times 14} \cdot \tilde{t}^{14 \times 1} = -p \cdot V_1^{16 \times 1} - k \cdot V_2^{16 \times 1} \tag{8B}$$

Die Werte für $k$ und $p$ werden bevorzugt jeweils zu 1 gewählt. Da die Nebendiagonalelemente der Untermatrizen $T_1, T_2, T_3, T_4$ verschwinden, wenn kein Übersprechen vorliegt, werden die Systemfehler $k$ und $p$ in Hauptdiagonalelementen der Untermatrizen $T_1, T_2, T_3, T_4$ positioniert. Außerdem ist der erste frei gewählte linear-in-T-Systemfehler $k$ ein linear-in-T-Systemfehler in einer rechten Spalte eines der Untermatrizen $T_1, T_2, T_3, T_4$ - beispielsweise $t_{15}$ - und der zweite frei gewählte linear-in-T-Systemfehler $p$ ein linear-in-T-Systemfehler in einer linken Spalte eines der Untermatrizen $T_1, T_2, T_3, T_4$ - beispielsweise $t_{12}$ - oder umgekehrt.

Da die Werte $k$ und $p$ für den ersten bzw. zweiten linear-in-T-Systemfehler lediglich Annahmen darstellen, die von den korrekten Werten für den ersten bzw. zweiten linear-in-T-Systemfehler abweichen können, stellen die durch Lösen des linearen Gleichungssystems gemäß Gleichung (8) sich ergebenden restlichen 14 linear-in-T-Systemfehler nur Zwischenergebnisse dar, die von den korrekten linear-in-T-Systemfehler noch abweichen können. Diese Zwischenergebnisse werden im Folgenden gemäß Gleichung (9) einer Matrix $\tilde{T}_i$ (i = engl. intermediate = Zwischenergebnis) zugeführt.

$$\tilde{T}_i = \begin{bmatrix} \tilde{T}_{1i} & \tilde{T}_{2i} \\ \tilde{T}_{3i} & \tilde{T}_{4i} \end{bmatrix} \tag{9}$$

$$\tilde{T}_{1i} = \begin{bmatrix} t_{0i} & t_{1i} \\ t_{2i} & t_{3i} \end{bmatrix} \tag{10A}$$

$$\tilde{T}_{2i} = \begin{bmatrix} t_{4i} & t_{5i} \\ t_{6i} & t_{7i} \end{bmatrix} \tag{10B}$$

$$\tilde{T}_{3i} = \begin{bmatrix} t_{8i} & t_{9i} \\ t_{10i} & t_{11i} \end{bmatrix} \tag{10C}$$

$$\tilde{T}_{4i} = \begin{bmatrix} p & t_{13i} \\ t_{14i} & k \end{bmatrix} \tag{10D}$$

Hinsichtlich der Elemente $t_{ji}$ der einzelnen Untermatrizen der Matrizen $\tilde{T}_i$ gemäß Gleichung (10A) bis (10D) kann folgende Eigenschaft abgeleitet werden:

Wenn man die einzelnen Matrizenmultiplikationen in Gleichung (4) durchführt, so erhält man rechts- und linksseitig des Gleichheitszeichen jeweils eine 4x4-Matrix, dessen Elemente 1,1 und 1,2 jeweils nur von den beiden Elementen in der linken Spalte von jeder der Untermatrizen $T_1$ bis $T_4$ und dessen Elemente 2,1 und 2,2 jeweils nur von den beiden Elementen in der rechten Spalte von jeder der Untermatrizen $T_1$ bis $T_4$ stammen. Da der frei gewählte Wert $p$ beispielsweise dem in der linken Spalte der Untermatrix $\tilde{T}_{4i}$ befindlichen linear-in-T-Systemfehler $t_{12}$ und der frei gewählte Wert $k$ beispielsweise dem in der rechten Spalte der Untermatrix $\tilde{T}_{4i}$ befindlichen linear-in-T-Systemfehler $t_{15}$ zugeordnet werden, müssen sämtliche linear-in-T-Systemfehler in einer linken Spalte der Untermatrizen $\tilde{T}_1$ bis $\tilde{T}_4$ eine Abhängigkeit einzig von $k$ und sämtliche linear-in-T-Systemfehler in einer rechten Spalte der Untermatrizen $\tilde{T}_{1i}$ bis $\tilde{T}_{4i}$ eine Abhängigkeit einzig von $p$ aufweisen, damit Gleichung (4) mit den in den Untermatrizen $\tilde{T}_{1i}$ bis $\tilde{T}_{4i}$ befindlichen Zwischenergebnissen für die linear-in-T-Systemfehler seine Gültigkeit weiterhin besitzt.

Um die Auswirkungen von $p$ bzw. $k$ aus den einzelnen mittels Lösen des linearen Gleichungssystems ermittelten linear-in-T-Systemfehlern $t_{ji}$ jeweils zu separieren, ist eine weitere Zwischengröße $t_{ji}'$ einzuführen, die sich für ein Element in der linken Spalte der Untermatrizen $\tilde{T}_{1i}$ bis $\tilde{T}_{4i}$ aus der Gewichtung des Verhältnisses zwischen dem jeweiligen korrekten linear-in-T-Systemfehler $t_j$ und dem korrekten linear-in-T-Systemfehler $t_{12}$ gemäß Gleichung (11A) mit dem frei gewählten Wert $p$ und für ein Element in der rechten Spalte der Untermatrizen $\tilde{T}_{1i}$ bis $\tilde{T}_{4i}$ aus der Gewichtung des Verhältnisses zwischen dem jeweiligen korrekten linear-in-T-Systemfehler $t_j$ und dem korrekten linear-in-T-Systemfehler $t_{15}$ gemäß Gleichung (11B) mit dem frei gewählten Wert $k$ ergibt. Gleichung (11A) und (11B) verdeutlichen die Normierung der übrigen 14 linear-in-T-Systemfehler durch die frei gewählten ersten und zweiten linear-in-T-Systemfehler $k$ und $p$.

$$t'_{ji} = \frac{t_j}{t_{12}} \qquad\qquad (11A)$$

$$t'_{ji} = \frac{t_j}{t_{15}} \qquad\qquad (11B)$$

Somit ergeben sich ausgehend von den Gleichungen (10A) bis (10D) für die Untermatrizen $\tilde{T}_{1i}$ bis $\tilde{T}_{4i}$ die Beziehungen in Gleichung (12A) bis (12B):

$$\tilde{T}_{1i} = \begin{pmatrix} pt'_{0i} & kt'_{1i} \\ pt'_{2i} & kt'_{3i} \end{pmatrix} = \underbrace{\begin{pmatrix} t'_{0i} & t'_{1i} \\ t'_{2i} & t'_{3i} \end{pmatrix}}_{T^*_{1i}} \cdot \underbrace{\begin{pmatrix} p & 0 \\ 0 & k \end{pmatrix}}_{N} \qquad (12A)$$

$$\tilde{T}_{2i} = \begin{pmatrix} pt'_{4i} & kt'_{5i} \\ pt'_{6i} & kt'_{7i} \end{pmatrix} = \cdot \underbrace{\begin{pmatrix} t'_{4i} & t'_{5i} \\ t'_{6i} & t'_{7i} \end{pmatrix}}_{T^*_{2i}} \cdot \underbrace{\begin{pmatrix} p & 0 \\ 0 & k \end{pmatrix}}_{N} \qquad (12B)$$

$$\tilde{T}_{3i} = \begin{pmatrix} pt'_{8i} & kt'_{9i} \\ pt'_{10i} & kt'_{11i} \end{pmatrix} = \underbrace{\begin{pmatrix} t'_{8i} & t'_{9i} \\ t'_{10i} & t'_{11i} \end{pmatrix}}_{T^*_{3i}} \cdot \underbrace{\begin{pmatrix} p & 0 \\ 0 & k \end{pmatrix}}_{N} \qquad (12C)$$

$$\tilde{T}_{4i} = \begin{pmatrix} p & kt'_{13i} \\ pt'_{14i} & k \end{pmatrix} = \underbrace{\begin{pmatrix} 1 & t'_{13i} \\ t'_{14i} & 1 \end{pmatrix}}_{T^*_{4i}} \cdot \underbrace{\begin{pmatrix} p & 0 \\ 0 & k \end{pmatrix}}_{N} \qquad (12D)$$

$$\frac{p_{kor}(k)}{p}$$

Gewichtet man die Elemente in der linken Spalte der Untermatrizen $\tilde{T}_{1i}$ bis $\tilde{T}_{4i}$ mit dem Verhältnis zwischen dem noch zu bestimmenden korrekten und vom frei gewählten ersten linear-in-T-Systemfehler $k$ abhängigen linear-in-T-Systemfehler $p_{kor}(k)$ und dem ursprünglich frei gewählten Wert $p$, so erhält man in Anlehnung an Gleichung (11A) bzw. (11B) den jeweiligen korrekten linear-in-T-Systemfehler $t_{j}$, die alle noch eine Abhängigkeit vom frei gewählten ersten linear-in-T-Systemfehler $k$ aufweisen. In Gleichung (13A) ist diese Gewichtung, die auch Renormalisierung genannt wird, dargestellt, die zu Untermatrizen $\tilde{T}_{1c}$ bis $\tilde{T}_{4c}$ führt. Die einzelnen Untermatrizen $\tilde{T}_{1c}$ bis $\tilde{T}_{4c}$ ergeben gemäß Gleichung (13B) die linear-in-T-Systemfehler-Matrix $\tilde{T}_{c}$.

$$\tilde{T}_{nc} = \tilde{T}_{ni} \cdot \begin{pmatrix} \dfrac{p_{kor}(k)}{p} & 0 \\ 0 & 1 \end{pmatrix} \qquad \mathtt{mit} \quad n = 1,2,3,4 \qquad (13A)$$

$$\tilde{T}_{c} = \begin{pmatrix} \tilde{T}_{1c} & \tilde{T}_{2c} \\ \tilde{T}_{3c} & \tilde{T}_{4c} \end{pmatrix} \qquad (13B)$$

Erfindungsgemäß wird der zweite linear-in-T-Systemfehler - beispielsweise der linear-in-T-Systemfehler $t_{12}$ mit dem ursprünglich frei gewählten Wert $p$ - in Abhängigkeit des ersten linear-in-T-Systemfehlers - beispielsweise der linear-in-T-Systemfehler $t_{15}$ mit dem ursprünglich frei gewählten Wert $k$ - gesetzt. Zur Bestimmung der Abhängigkeit des zweiten linear-in-T-Systemfehlers vom ersten linear-in-T-Systemfehler wird die Reziprozität des fünften reziproken und transmissionsbehafteten Kalibrierstandards $R$ gemäß Gleichung (7E) benutzt.

Hierzu wird ausgehend von einer ebenfalls in Silvonen K. "New Five-Standard Calibration Procedures for Network Analyzers and Wafer Probes", ISBN 951-22-1989-1, 24. Juli 1998, vorgestellten mathematischen Beziehung zwischen den gemessenen Streuparametern $S_{m}$ und den tatsächlichen Streuparametern $S_{a}$ eines Messobjekts und den einzelnen Untermatrizen der Systemfehlermatrix T gemäß Gleichung (14) eine mathematische Beziehung für Streuparameter $\tilde{S}_{aRez}$ des fünften reziproken und transmissionsbehafteten Kalibrierstandards gemäß Gleichung (15) mit einer faktorisierten Beziehung für die einzelnen Untermatrizen $\tilde{T}_{1}$ bis $\tilde{T}_{4}$ aus Gleichung (12A) bis (12D) eingeführt. Der gemäß Gleichung (15) ermittelte Streuparameter $\tilde{S}_{aRez}$ des fünften reziproken und transmissionsbehafteten Kalibrierstandards ist noch nicht systemfehlerbereinigt, da die in der Transformation verwendeten Untermatrizen $\tilde{T}_{1}$ bis $\tilde{T}_{4}$ noch eine Abhängigkeit von den ursprünglich frei festgelegten ersten und zweiten linear-in-T-Systemfehlern $k$ und $p$ aufweisen, die noch nicht exakt ermittelt sind. Somit stellen die Streuparameter $\tilde{S}_{aRez}$ Zwischengrößen dar und werden im Folgenden lediglich als transformierte Streuparameter $\tilde{S}_{aRez}$ bezeichnet.

$$S_{a} = (T_{1} - S_{m} \cdot T_{3})^{-1} \cdot (S_{m} \cdot T_{4} - T_{2}) \qquad (14)$$

$$\tilde{S}_{arez} = \left[ T_{1i} - S_{mrez} \cdot T_{3i} \right]^{-1} \cdot \left[ S_{mrez} \cdot T_{4i} - T_{2i} \right] = $$
$$= \left[ T_{1i}^{*} \cdot N - S_{mrez} \cdot T_{3i}^{*} \cdot N \right]^{-1} \cdot \left[ S_{mrez} \cdot T_{4i}^{*} \cdot N - T_{2i}^{*} \cdot N \right] \qquad (15)$$

Eine mathematische Umformung der Gleichung (15) führt zu einer mathematischen Beziehung für die transformierten Streuparameter $\tilde{S}_{aRez}$ des fünften reziproken und transmissionsbehafteten Kalibrierstandards gemäß Gleichung (16) :

$$\tilde{S}_{a\,rez} = \left[\left(T_{1i}^* - S_{m\,rez} \cdot T_{3i}^*\right) \cdot N\right]^{-1} \cdot \left[\left(S_{m\,rez} \cdot T_{4i}^* - T_{2i}^*\right) \cdot N\right] =$$

$$= \left[\left(N^{-1} \cdot (T_{1i}^* - S_{m\,rez} \cdot T_{3i}^*\right)^{-1}\right] \cdot \left[\left(S_{m\,rez} \cdot T_{4i}^* - T_{2i}^*\right) \cdot N\right] =$$

$$= N^{-1} \cdot \underbrace{\left(T_{1i}^* - S_{m\,rez} \cdot T_{3i}^*\right)^{-1} \cdot \left(S_{m\,rez} \cdot T_{4i}^* - T_{2i}^*\right)}_{F_i} \cdot N = N^{-1} \cdot F_i \cdot N \qquad (16)$$

Aus Gleichung (16) lassen sich die mathematischen Beziehungen für die beiden transformierten und zueinander reziproken Transmissionskoeffizienten $\tilde{S}_{arez}(1,2)$ und $\tilde{S}_{arez}(2,1)$ des fünften reziproken und transmissionsbehafteten Kalibrierstandards zu den frei gewählten Parametern $k$ und $p$ des ersten und zweiten linear-in-T-Systemfehler gemäß Gleichung (17A) bzw. (17B) bestimmen:

$$\tilde{S}_{a\,rez}(1,2) = \frac{k}{p} \cdot F_i(1,2) \qquad (17A)$$

$$\tilde{S}_{a\,rez}(2,1) = \frac{p}{k} \cdot F_i(2,1) \qquad (17B)$$

Die Reziprozitätsbedingung $\tilde{S}_{arez}(1,2) = \tilde{S}_{arez}(2,1)$ zwischen den beiden transformierten und zueinander reziproken Transmissionskoeffizienten $\tilde{S}_{arez}(1,2)$ und $\tilde{S}_{arez}(2,1)$ des fünften transmissionsbehafteten und reziproken Kalibrierstandards gilt nur für den Fall einer korrekten Wahl der Parameter $p$ und $k$. Werden die Parameter $p$ und $k$ nicht korrekt gewählt, da das noch unbekannte Abhängigkeitsverhältnis zwischen den Parametern $p$ und $k$ bei der freien Wahl der Parametern $p$ und $k$ typischerweise noch nicht berücksichtigt ist, so besteht zwischen den beiden transformierten Transmissionskoeffizienten $\tilde{S}_{arez}(1,2)$ und $\tilde{S}_{arez}(2,1)$ gemäß Gleichung (18) ein noch unbekannter Verhältnisfaktor $M$ :

$$\frac{\tilde{S}_{a\,rez}(1,2)}{\tilde{S}_{a\,rez}(2,1)} = M = \frac{k^2 F_i(1,2)}{p^2 F_i(2,1)} \qquad (18)$$

Der Verhältnisfaktor $M$ folgt somit direkt aus den transformierten Transmissionskoeffizienten $\tilde{S}_{arez}(1,2)$ und $\tilde{S}_{arez}(2,1)$ und weist die in Gleichung (18) dargestellte Abhängigkeit von den frei gewählten Parametern $p$ und $k$ des ersten und zweiten linear-in-T-Systemfehlers auf.

Damit die aus der Reziprozität des fünften transmissionsbehafteten Kalibrierstandards folgende Identität der Transmissionskoeffizienten auch für die transformierten Transmissionskoeffizienten $\tilde{S}_{arez}(1,2)$ und $\tilde{S}_{arez}(2,1)$ gilt, muss das Verhältnis der frei gewählten Parameter derart korrigiert werden, dass der Verhältnisfaktor $M$ in Gleichung (18) den Wert Eins ergibt.

Es muss somit ein korrekter zweiter linear-in-T-Systemfehler $p_{kor}(k)$ gefunden werden, der eine Abhängigkeit vom frei gewählten ersten linear-in-T-Systemfehler $k$ aufweist und das Verhältnis zwischen den ursprünglich frei gewählten ersten und zweiten linear-in-T-Systemfehler $k$ und $p$ korrigiert. Ausgehend von Gleichung (18) ergibt sich somit eine Gleichung (19), die eine Bestimmungsgleichung für den korrekten zweiten linear-in-T-Systemfehler $p_{kor}(k)$ liefert.

$$\frac{k^2 \cdot F_i(1,2)}{F_i(2,1) \cdot p_{kor}(k)} = 1 \qquad (19)$$

Aus Gleichung (19) folgt somit ebenfalls in Anlehnung an Gleichung (18) eine mathematische Beziehung für den Verhältnisfaktor $M$ gemäß Gleichung (20).

$$M \cdot \frac{p^2}{p^2_{kor}(k)} = 1 \qquad (20)$$

Der korrekte zweite linear-in-T-Systemfehler $p_{kor}(k)$ in Abhängigkeit des frei gewählten ersten linear-in-T-Systemfehlers $k$ ergibt sich somit gemäß Gleichung (21).

$$p_{kor}(k) = \pm\sqrt{M \cdot p^2} \qquad (21)$$

Nach der Renormalisierung gemäß Gleichung (13A) weisen die 15 linear-in-T-Systemfehler $t_{ji}$ nur noch eine Abhängigkeit vom frei gewählten ersten linear-in-T-Systemfehler $k$ auf. Mit den so bestimmten 16 linear-in-T-Systemfehlern $t_{ji}$ ist eine korrekte Fehlerkorrektur möglich.

Das beim korrekten Wert des korrekten zweiten linear-in-T-Systemfehlers $p_{kor}$ zusätzlich zu berücksichtigende korrekte Vorzeichen - das Vorzeichen, das gemäß Gleichung (21) aus der Wurzelbildung resultiert - kann bei bekannten korrekten Wert des korrekten zweiten linear-in-T-Systemfehlers $p_{kor}$ mit Plausibilitätsüberlegungen zwischen der bekannten elektrischen Länge und den mit den nach Gleichung (13A) für beide Vorzeichenmöglichkeiten ermittelbaren und nach Gleichung (14) transformierten Streuparametern $\tilde{S}_{arez}$ des transmissionsbehafteten und reziproken Kalibrierstandards abgeleitet werden. Die elektrische Länge des transmissionsbehafteten und reziproken Kalibrierstandards muss nicht exakt bekannt sein. Eine Genauigkeit der elektrischen Länge in Höhe von $\pm 90°$ ist für die Bestimmung ausreichend.

Auf diese Weise lassen sich die linear-in-T-Systemfehler des Netzwerkanalysators, der Hochfrequenzleitungen und der Messhalterung bestimmen. Mit den so bestimmten Systemfehlern können die Messwerte von unbekannten zu charakterisierenden Messobjekten nach Gleichung (14) von den Systemfehlern des Netzwerkanalysators, der Hochfrequenzleitungen und der Messhalterung befreit werden.

Mit dem Erfindungsgedanken lässt sich zusätzlich eine Messhalterung, die mit dem Netzwerkanalysator über die Hochfrequenzmessleitungen verbunden ist und in der Kalibrierstandards oder ein zu charakterisierendes Messobjekt fixiert ist, charakterisieren. Die Reflexions- und Transmissionskoeffizienten der Messhalterung sowie die einzelnen Terme, die ein Übersprechen innerhalb der Messhalterung beschreiben, werden hierbei als zu bestimmende Systemfehler betrachtet, die zwischen Messobjekt bzw. Kalibrierstandard und Netzwerkanalysator oder zwischen der Referenzebene 1 und 2 gemäß Fig. 4 auftreten.

Nachdem vorab die Systemfehler des Netzwerkanalysators und der Hochfrequenzleitungen im Rahmen einer Vorabkalibrierung bestimmt werden, werden hierzu in der Referenzebene 1 Streuparameter von reziproken und transmissionslosen Kalibrierstandards gemessen, die jeweils nacheinander in der Messhalterung fixiert werden. Aus den gemessenen Streuparametern und den tatsächlichen Streuparametern der einzelnen Kalibrierstandards lassen sich wie beim obig beschriebenen Kalibrierverfahren 14 linear-in-T-Systemfehler mittels Lösen eines linearen Gleichungssystems ermitteln, wenn ein erster linear-in-T-Systemfehler $k$ und ein zweiter linear-in-T-Systemfehler $p$ jeweils frei gewählt werden.

Zur Ermittlung der Reflexions- und Transmissionskoeffizienten der Messhalterung sowie die einzelnen Terme, die ein Übersprechen innerhalb der Messhalterung beschreiben, werden die einzelnen linear-T-Systemfehler in korrespondierende Systemfehler einer Systemfehlermatrix E des 16-Term-Fehlermodells transformiert.

Die Untermatrizen $\tilde{E}_{1i}$ bis $\tilde{E}_{4i}$ der Systemfehlermatrix $\tilde{E}_i$ des 16-Term-Fehlermodells lassen sich, wie ebenfalls in Silvonen K. "New Five-Standard Calibration Procedures for Network Analyzers and Wafer Probes", ISBN 951-22-1989-1, 24. Juli 1998, vorgestellt ist, durch Transformation der Untermatrizen $\tilde{T}_{1i}$ bis $\tilde{T}_{4i}$ der linear-in-T-Systemfehler-Matrix $\tilde{T}_i$ gemäß der Gleichungen (22A) bis (22D) bestimmen.

$$\tilde{E}_{1i} = \tilde{T}_{2i}\tilde{T}_{4i}^{-1} \qquad (22A)$$

$$\tilde{E}_{3i} = \tilde{T}_{4i}^{-1} \qquad (22B)$$

$$\tilde{E}_{2i} = \tilde{T}_{1i} - \tilde{T}_{2i}\tilde{T}_{4i}^{-1}\tilde{T}_{3i} \qquad (22C)$$

$$\tilde{E}_{4i} = -\tilde{T}_{4i}^{-1}\tilde{T}_{3i} \qquad (22D)$$

Die hierzu erforderliche inverse Untermatrix $\tilde{T}_{4i}^{-1}$ lässt sich gemäß Gleichung (23) berechnen.

$$\tilde{T}_{4i}^{-1} = \begin{pmatrix} \dfrac{1}{p}d_{11} & \dfrac{1}{p}d_{12} \\ \dfrac{1}{k}d_{21} & \dfrac{1}{k}d_{22} \end{pmatrix} \quad \mathtt{mit}$$

$$d_{11} = \frac{-1}{t_1' t_{13}' - 1} \quad d_{12} = \frac{t_{12}'}{t_{12}' t_{13}' - 1}$$

$$d_{21} = \frac{t_{13}'}{t_1' t_{13}' - 1} \quad d_{22} = \frac{-1}{t_{12}' t_{13}' - 1} \tag{23}$$

Nach Durchführung der Matrizenmultiplikationen ergeben sich die Untermatrizen $\tilde{E}_{1i}$ bis $\tilde{E}_{4i}$ der Systemmatrix $\tilde{E}_i$ gemäß Gleichung (24A) bis (24D):

$$\tilde{E}_{1i} = \begin{pmatrix} -\dfrac{t_0' - t_1' t_{13}'}{t_{12}' t_{13}' - 1} & -\dfrac{t_1' - t_0' t_{12}'}{t_{12}' t_{13}' - 1} \\ -\dfrac{t_2' - t_3' t_{13}'}{t_{12}' t_{13}' - 1} & -\dfrac{t_3' - t_2' t_{12}'}{t_{12}' t_{13}' - 1} \end{pmatrix} \tag{24A}$$

$$\tilde{E}_{2i} = \begin{pmatrix} \left( \dfrac{t_0' t_{13}' - t_4' t_{10}'}{t_{13}'} - \dfrac{(t_4' - t_5' t_{13}')(t_{10}' - t_8' t_{13}')}{t_{13}'(t_{12}' t_{13}' - 1)} \right)p & \left( \dfrac{t_1' t_{13}' - t_4' t_{11}'}{t_{13}'} - \dfrac{(t_4' - t_5' t_{13}')(t_{11}' - t_9' t_{13}')}{t_{13}'(t_{12}' t_{13}' - 1)} \right)k \\ \left( \dfrac{t_2' t_{13}' - t_6' t_{10}'}{t_{13}'} - \dfrac{(t_6' - t_7' t_{13}')(t_{10}' - t_8' t_{13}')}{t_{13}'(t_{12}' t_{13}' - 1)} \right)p & \left( \dfrac{t_3' t_{13}' - t_6' t_{11}'}{t_{13}'} - \dfrac{(t_6' - t_7' t_{13}')(t_{11}' - t_9' t_{13}')}{t_{13}'(t_{12}' t_{13}' - 1)} \right)k \end{pmatrix}$$

$$\tag{24B}$$

$$E_{3i} = \begin{pmatrix} -\dfrac{1}{(t_{12}' t_{13}' - 1)p} & \dfrac{t_{12}'}{(t_{12}' t_{13}' - 1)p} \\ \dfrac{t_{13}'}{(t_{12}' t_{13}' - 1)k} & -\dfrac{1}{(t_{12}' t_{13}' - 1)k} \end{pmatrix} \tag{24C}$$

$$\tilde{E}_{4i} = \begin{pmatrix} \dfrac{t_8' - t_{10}' t_{12}'}{t_{12}' t_{13}' - 1} & \dfrac{k(t_9' - t_{11}' t_{12}')}{p(t_{12}' t_{13}' - 1)} \\ \dfrac{p(t_{10}' - t_8' t_{13}')}{k(t_{12}' t_{13}' - 1)} & \dfrac{t_{11}' - t_{11}' t_{12}'}{t_{12}' t_{13}' - 1} \end{pmatrix} \tag{24D}$$

Gleichungen (24A) bis (24D) verdeutlichen die Auswirkungen der beiden frei gewählten Parameter $k$ und $p$ für den ersten bzw. zweiten linear-in-T-Systemfehler auf die Berechnung der Matrizen $\tilde{E}_{ji}$.

Die im Signalflussgraf in Fig. 2 dargestellten Transmissions-, Reflexions- und Übersprech-Parameter einer 4-Tor-Einheit lassen sich in die Untermatrizen $\tilde{E}_{1i}$ bis $\tilde{E}_{4i}$ der Systemfehlermatrix $\tilde{E}_i$ gemäß Gleichung (25A) bis (25D), die eine Abhängigkeit von den frei gewählten ersten und zweiten linear-in-T-Systemfehler $k$ und $p$ aufweisen, einfügen. Die für die weitere Betrachtung relevanten Fehlerterme der Untermatrizen $\tilde{E}_{2i}$ und $\tilde{E}_{3i}$ mit den Transmissions- und Übersprech-Parametern einer 4-Tor-Einheit ergeben sich somit gemäß Gleichung (25A) bzw. (25B) :

$$\widetilde{E}_{2i} = \begin{pmatrix} p \cdot e_{01i} & k \cdot e_{02i} \\ p \cdot e_{31i} & k \cdot e_{32i} \end{pmatrix} \qquad (25\text{A})$$

$$\widetilde{E}_{3i} = \begin{pmatrix} \dfrac{1}{p} \cdot e_{10i} & \dfrac{1}{p} \cdot e_{13i} \\ \dfrac{1}{k} \cdot e_{20i} & \dfrac{1}{k} \cdot e_{23i} \end{pmatrix} \qquad (25\text{B})$$

Aus den beiden allgemeinen Reziprozitätsbedingungen $e_{10} = e_{01}$ und $e_{23} = e_{32}$ zwischen jeweils zwei zueinander reziproken Transmissionskoeffizienten der beiden Transmissionspfade der Messhalterung gemäß dem Signalflussgraf in Fig. 2 lassen sich die in Gleichung (26A) und (26B) dargestellten Reziprozitätsbedingungen für die weitere Betrachtung ableiten:

$$\widetilde{E}_{2i}(1,1) = \widetilde{E}_{3i}(1,1) \qquad (26\text{A})$$

$$\widetilde{E}_{2i}(2,2) = \widetilde{E}_{3i}(2,2) \qquad (26\text{B})$$

Da der erste linear-in-T-Systemfehler $k$ und der zweite linear-in-T-Systemfehler $p$ üblicherweise nicht korrekt gewählt wird, ergibt der Quotient zwischen den Matrixelementen $\tilde{E}_{2i}(1,1)$ und $\tilde{E}_{3i}(1,1)$ aus Gleichung (26A) und der Quotient zwischen den Matrixelementen $\tilde{E}_{2i}(2,2)$ und $\tilde{E}_{3i}(2,2)$ aus Gleichung (26B) einen von Eins verschiedenen Verhältnisfaktor $M$. Dieser Verhältnisfaktor $M$ ergibt sich jeweils ausgehend von (26A) bzw. (26B) unter Berücksichtigung von Gleichung (25A) und (25B) jeweils gemäß Gleichung (27A) bzw. (27B).

$$M = \frac{\widetilde{E}_{3i}(1,1)}{\widetilde{E}_{2i}(1,1)} = \frac{e_{10i}}{p^2 \cdot e_{01i}} \qquad (27\text{A})$$

$$M = \frac{\widetilde{E}_{3i}(2,2)}{\widetilde{E}_{2i}(2,2)} = \frac{e_{23i}}{k^2 \cdot e_{32i}} \qquad (27\text{B})$$

Wird in Gleichung (27A) anstelle des frei gewählten zweiten linear-in-T-Systemfehlers $p$ der korrekte zweite linear-in-T-Systemfehler $p_{kor}$ gewählt, so ergibt sich gemäß Gleichung (28A) ein Verhältnisfaktor $M = 1$. Wird äquivalent in Gleichung (27B) anstelle des frei gewählten ersten linear-in-T-Systemfehlers $k$ der korrekte erste linear-in-T-Systemfehler $k_{kor}$ gewählt, so ergibt sich gemäß Gleichung (28B) ebenfalls ein Verhältnisfaktor $M = 1$.

$$\frac{e_{10i}}{p^2_{\,kor} \cdot e_{01i}} = 1 \qquad (28\text{A})$$

$$\frac{e_{23i}}{k^2_{\,kor} \cdot e_{32i}} = 1 \qquad (28\text{B})$$

Aus Gleichung (28A) bzw. (28B) folgt somit ebenfalls in Anlehnung an Gleichung (27A) bzw. (27B) eine mathematische Beziehung für den Verhältnisfaktor $M$ gemäß Gleichung (29A) bzw. (29B).

$$M \cdot \frac{p^2}{p^2_{\,kor}} = 1 \qquad (29\text{A})$$

$$M \cdot \frac{k^2}{k^2_{kor}} = 1 \qquad (29B)$$

Somit ergibt sich ausgehend von Gleichung (29A) eine mathematische Beziehung für den korrekten zweiten linear-in-T-Systemfehler $p_{kor}$ und ausgehend von Gleichung (29B) eine mathematische Beziehung für den korrekten ersten linear-in-T-Systemfehler $k_{kor}$.

$$p_{kor} = \pm\sqrt{M \cdot p^2} \qquad (30A)$$

$$k_{kor} = \pm\sqrt{M \cdot k^2} \qquad (30B)$$

Das beim Wert zusätzlich zu berücksichtigende Vorzeichen der korrekten ersten und zweiten linear-in-T-Systemfehler $p_{kor}$ und $k_{kor}$ kann bei bekanntem korrekten Wert der korrekten ersten und zweiten linear-in-T-Systemfehler $p_{kor}$ und $k_{kor}$ anhand von Plausibilitätsüberlegungen zwischen der bekannten elektrischen Länge und den transformierten und zueinander reziproken Transmissionskoeffizienten $\tilde{E}_{2i}(1,1)$ und $\tilde{E}_{3i}(1,1)$ sowie $\tilde{E}_{2i}(2,2)$ und $\tilde{E}_{3i}(2,2)$ der beiden Transmissionspfade der Messhalterung abgeleitet werden. Auch hier ist eine genaue Kenntnis der elektrischen Länge nicht nötig. Eine auf $\pm 90°$ genaue Schätzung ist für die korrekte Bestimmung des korrekten Vorzeichens ausreichend.

Die einzelnen, teilweise von den ursprünglich frei gewählten ersten und zweiten Systemfehlern $k$ und $p$ abhängigen Untermatrizen $\tilde{E}_{1i}$ bis $\tilde{E}_{4i}$ der Systemfehlermatrix $\tilde{E}_i$ gehen in die von den ursprünglich frei gewählten ersten und zweiten Systemfehlern $k$ und $p$ bereinigten Untermatrizen $\tilde{E}_{1c}$ bis $\tilde{E}_{4c}$ der Systemfehlermatrix $\tilde{E}_c$ über, indem die einzelnen Elemente der ursprünglich aus dem linearen Gleichungssystem ermittelten linear-in-T-Systemfehler-Untermatrizen $\tilde{T}_{ni}$ gemäß Gleichung (31A) mit den Verhältnis zwischen dem korrekten ersten linear-in-T-Systemfehler $k_{kor}$ und dem ursprünglich frei gewählten ersten linear-in-T-Systemfehler $k$ oder mit den Verhältnis zwischen dem korrekten zweiten linear-in-T-Systemfehler $p_{kor}$ und dem ursprünglich frei gewählten zweiten linear-in-T-Systemfehler $p$ im Rahmen der Renormalisierung gewichtet werden. In Anlehnung an die Gleichungen (22A) bis (22D) werden aus den renormalisierten Systemfehler-Untermatrizen $\tilde{T}_{ci}$ die zugehörigen Systemfehleruntermatrizen $\tilde{E}_{ci}$ der Systemfehlermatrix $\tilde{E}_c$ gemäß Gleichung (31B) bestimmt.

$$T_{nc} = \tilde{T}_{ni} \cdot \begin{bmatrix} \dfrac{p_{kor}}{p} & 0 \\ 0 & \dfrac{k_{kor}}{k} \end{bmatrix} \qquad (31A)$$

$$E_c = \begin{bmatrix} E_{1c} & E_{2c} \\ E_{3c} & E_{4c} \end{bmatrix} \qquad (31B)$$

Im Folgenden wird das erfindungsgemäße Verfahren zur Kalibrierung einer Messanordnung anhand eines 16-Term-Fehlermodells mithilfe des Flussdiagrammes in Fig. 5 in Kombination mit dem erfindungsgemäßen System zur Kalibrierung einer Messanordnung anhand eines 16-Term-Fehlermodells mithilfe des Blockdiagramms in Fig. 4 im Detail erläutert.

Im ersten Verfahrensschritt S10 des erfindungsgemäßen Verfahrens werden die beiden Messtore $P_1$ und $P_2$ des vektoriellen Netzwerkanalysators 1 über die beiden Hochfrequenz-Messleitungen $2_1$ und $2_2$ nacheinander mit fünf Kalibrierstandards 3 verbunden und die Streuparameter $S_m$ der fünf Kalibrierstandards gemessen. Bei den fünf Kalibrierstandards handelt es sich um vorzugsweise vier transmissionslose Kalibrierstandards gemäß Gleichung (7A) bis (7D) in einer der beispielhaften Kombinationen, die in der Tabelle der Fig. 10 dargestellt sind, und um einen fünften transmissionsbehafteten und reziproken Kalibrierstandard gemäß Gleichung (7E).

Im darauffolgenden Verfahrensschritt S20 wird ein lineares Gleichungssystem gemäß Gleichung (9B) erstellt. In die 16x14-dimensionale Matrix $\tilde{A}^{16\times14}$ und in die 16-dimensionalen Vektoren $V_1^{16x1}$ und $V_2^{16x1}$ gehen die gemessenen Streuparameter $S_m$ und die tatsächlichen Streuparameter $S_a$ der vier transmissionslosen Kalibriestandards äquivalent zu Gleichung (6A) für den Fall eines einzigen Kalibrierstandards ein.

Für die frei gewählten ersten und zweiten linear-in-T-Systemfehler $k$ und $p$ können beliebige Werte außer $k =$

0 und $p = 0$ verwendet werden. Bevorzugt wird jeweils ein Wert 1 gewählt, da sich in diesem Fall die Normierung der 14 übrigen linear-in-T-Systemfehler im Abschluss des erfindungsgemäßen Verfahrens vereinfacht.

Die 14 zu bestimmenden linear-in-T-Systemfehler werden im nächsten Verfahrensschritt S30 in Abhängigkeit der frei gewählten ersten und zweiten linear-in-T-Systemfehler $k$ und $p$ durch Lösen des linearen Gleichungssystems ermittelt. Hierzu können gängige numerische Verfahren zum Lösen von linearen Gleichungssystemen wie beispielsweise das Verfahren zur Eigenwertzerlegung, das Gauss-Jordan-Verfahren oder das Newton-Raphson-Verfahren zur Anwendung kommen.

In den nächsten beiden Verfahrensschritten S40 und S50 wird die Abhängigkeit des zweiten linear-in-T-Systemfehlers $p$, der ursprünglich frei gewählt wurde und von nun an nicht mehr unabhängig ist, zum frei gewählten und weiterhin unabhängigen ersten linear-in-T-Systemfehler $k$ ermittelt, um insgesamt 15 abhängige linear-in-T-Systemfehler und einen unabhängigen linear-in-T-Systemfehler $k$ für die 16-dimensionale Lösung zu finden.

Im Verfahrensschritt S40 wird der Wert des zweiten linear-in-T-Systemfehler $p$ in Abhängigkeit des frei gewählten Werts des ersten linear-in-T-Systemfehlers $k$ bestimmt. Hierzu werden gemäß Gleichung (15) die transformierten Transmissionskoeffizienten $\tilde{S}_{arez}(1,2)$ und $\tilde{S}_{arez}(2,1)$ des als Kalibrierstandard 3 verwendeten fünften transmissionsbehafteten und reziproken Kalibrierstandards $R$ aus Gleichung (7E) ermittelt, indem die gemessenen Streuparameter $S_{mrez}$ dieses fünften transmissionsbehafteten und reziproken Kalibrierstandards mit den im letzen Verfahrensschritt S30 bestimmten Untermatrizen $\tilde{T}_{1i}$ bis $\tilde{T}_{4i}$ der linear-in-T-Systemfehlermatrix $\tilde{T}_i$ transformiert werden.

Der korrekte Wert $p_{kor}(k)$ für den zweiten linear-in-T-Systemfehler in Abhängigkeit des frei gewählten Parameters $k$ für den ersten linear-in-T-Systemfehler lässt sich gemäß Gleichung (21) ermitteln.

Im Verfahrensschritt S50 wird das beim korrekten Wert des zweiten linear-in-T-Systemfehlers $p_{kor}(k)$ zusätzlich aufgrund der Wurzelbildung zu berücksichtige Vorzeichen anhand von Plausibilitäten zwischen der bekannten elektrischen Länge und den im obigen Verfahrensschritt S40 ermittelten transformierten Streuparametern $\tilde{S}_{arez}$ des fünften transmissionsbehafteten und reziproken Kalibrierstandards bestimmt. Hierzu wird für jedes Vorzeichen der Wurzel in Gleichung (21) jeweils der zugehörige "vorzeichenbehaftete" korrekte Wert des zweiten linear-in-T-Systemfehlers $p_{kor}(k)$ zur Bestimmung von 15-linear-in-T-Systemfehlern, die einzig vom frei gewählten ersten linear-in-T-Systemfehler $k$ abhängig sind, mittels "Renormalisierung" der in Verfahrensschritt S30 ermittelten 14 linear-in-T-Systemfehler gemäß Gleichung (13A) verwendet. Mit den somit ermittelten 15 linear-in-T-Systemfehlern werden die gemessenen Streuparameter des fünften transmissionsbehafteten und reziproken Kalibrierstandards zur Ermittlung von tatsächlichen Streuparametern nach Gleichung (14) transformiert (sogenanntes De-Embedding). Durch Vergleich der Phase der beiden somit ermittelten und zueinander reziproken Transmissionskoeffizienten mit der bekannten elektrischen Länge des fünften transmissionsbehafteten und reziproken Kalibrierstandards kann das zum korrekten Wert des zweiten linear-in-T-Systemfehler zusätzlich zu berücksichtigende korrekte Vorzeichen mittels Plausibilitätsüberlegung ermittelt werden.

Im abschließenden Verfahrensschritt S60 werden die korrekten linear-in-T-Systemfehler für die einzelnen Untermatrizen $\tilde{T}_{1c}$ bis $\tilde{T}_{4c}$ der linear-in-T-Systemfehler-Matrix $\tilde{T}_c$, die nur noch eine Abhängigkeit vom ersten frei gewählten linear-in-T-Systemfehler $k$ aufweisen, für die weitere Verwendung gespeichert, wohingegen der Lösungsvektor bei Verwendung des falschen Vorzeichens verworfen wird.

Mit den Elementen der linear-in-T-Systemfehler-Matrix $\tilde{T}_c$ können mit dem vektoriellen Netzwerkanalysator gemessene Streuparameter eines Messobjekts von den Systemfehlern des Netzwerkanalysators, der Messleitungen und der Messhalterung bereinigt werden. Hierzu ist beispielsweise die mathematische Beziehung zur Systemfehlerbereinigung in Gleichung (14) anzuwenden.

Im Folgenden wird die erste Ausführungsform des erfindungsgemäßen Verfahrens zur Charakterisierung einer mit einem Netzwerkanalysator verbundenen Messhalterung anhand des Flussdiagrammes in Fig. 6A in Kombination mit dem erfindungsgemäßen System zur Charakterisierung einer mit einem Netzwerkanalysator verbundenen Messhalterung im Blockdiagramm der Fig. 4 im Detail erläutert.

Im ersten Verfahrensschritt S100 des erfindungsgemäßen Verfahrens werden die durch den vektoriellen Netzwerkanalysator und die Hochfrequenzmessleitungen verursachten Systemfehler mittels einer Kalibrierung ermittelt. Hierzu können gängige Kalibrierverfahren nach dem Stand der Technik angewendet werden, die durch Messung der Streuparameter von Kalibrierstandards Parameter zur Fehlerkorrektur bestimmen.

Im darauffolgenden Verfahrensschritt S110 werden äquivalent zu Verfahrensschritt S10 beim erfindungsgemäßen Verfahren zur Kalibrierung einer Messanordnung z.B. anhand eines 16-Term-Fehlermodells die Streuparameter von z.B. insgesamt vier transmissionslosen und reziproken Kalibrierstandards gemäß Gleichung (7A) bis (7D) und eines fünften transmissionsbehafteten und reziproken Kalibrierstandards gemäß Gleichung (7E), die in einer Messhalterung 4 gemäß Fig. 5 nacheinander fixiert sind, in einer Referenzebene 1 gemäß Fig. 4 gemessen.

Die in der Referenzebene 1 jeweils gemessenen Streuparameter $S_m$ werden anschließend mit dem im vorherigen Verfahrensschritt S10 ermittelten Parametern nach einer geeigneten Methode von den ermittelten Systemfehlern des Netzwerkanalysators 1 und der Messleitungen $2_1$ und $2_2$ bereinigt.

Im darauffolgenden Verfahrensschritt S120 werden in Äquivalenz zu Verfahrensschritt S20 beim erfindungsgemäßen Verfahren zur Kalibrierung eines Netzwerkanalysators anhand z.B. eines 16-Term-Fehlermodells ein lineares Gleichungssystem gemäß Gleichung (8B) erstellt. Die Matrix $\tilde{A}^{16 \times 14}$ und die Vektoren $V_1^{16x1}$ und $V_2^{16x1}$ enthalten jeweils die tatsächlichen und die gemessenen Streuparameter der vier transmissionslosen und reziproken Kalibrierstandards. Der erste und zweite linear-in-T-Systemfehler $k$ und $p$ werden jeweils geeignet, bevorzugt mit dem Wert 1, festgelegt.

Die Bestimmung der 14 unbekannten linear-in-T-Systemfehler in Abhängigkeit der festgelegten ersten und zweiten linear-in-T-Systemfehler $k$ und $p$ durch Lösen des linearen Gleichungssystem im darauffolgenden Verfahrensschritt S130 entspricht dem Verfahrensschritt S30 beim erfindungsgemäßen Verfahren zur Kalibrierung einer Messanordnung anhand eines 16-Term-Fehlermodells.

Die auf diese Weise ermittelten oder frei festgelegten linear-in-T-Systemfehler werden den vier Untermatrizen $\tilde{T}_{1i}$ bis $\tilde{T}_{4i}$ gemäß Gleichung (12A) bis (12D) zugeführt. Aus den Elementen dieser linear-in-T-Systemfehler-Untermatrizen $\tilde{T}_{1i}$ bis $\tilde{T}_{4i}$ werden im nächsten Verfahrensschritt S140 die korrespondierenden Systemfehler-Untermatrizen $\tilde{E}_{1i}$ bis $\tilde{E}_{4i}$ des 16-Term-Fehlermodells unter Anwendung der Gleichungen (23) und (24A) bis (24D) bestimmt.

Die auf diese Weise ermittelten Systemfehler in den Systemfehler-Untermatrizen $\tilde{E}_{1i}$ bis $\tilde{E}_{4i}$ des 16-Term-Fehlermodells korrespondieren zu den im Signalflussgraf der Fig. 2 dargestellten Parametern, die für eine 4-Tor-Einheit das Transmissionsverhalten - Elemente $e_{01}, e_{10}, e_{23}, e_{32}$ in Fig. 2 -, das Reflexionsverhalten - Elemente $e_{00}, e_{11}, e_{22}, e_{33}$ in Fig. 2 - und das Übersprechverhalten - Elemente $e_{30}, e_{03}, e_{20}, e_{13}, e_{31}, e_{02}, e_{21}, e_{12}$ in Fig. 2 - beschreiben. Auf diese Weise ist es möglich, mittels Bestimmen der Systemfehler in den Systemfehler-Matrizen $\tilde{E}_{1i}$ bis $\tilde{E}_{4i}$ des 16-Term-Fehlermodells das Transmissions-, Reflexions- und Übersprechverhalten der Messhalterung, in der Kalibrierstandards oder ein Messobjekt fixiert sind, zu charakterisieren.

Da die einzelnen Elemente der Systemfehler-Matrizen $\tilde{E}_{1i}$ bis $\tilde{E}_{4i}$ des 16-Term-Fehlermodells teilweise auch Abhängigkeiten vom ersten und/oder zweiten linear-in-T-Systemfehler $k$ und $p$ aufweisen, werden in den folgenden Verfahrensschritten S150 und S160 sowohl der erste linear-in-T-Systemfehler $k$ als auch der zweite linear-in-T-Systemfehler $p$ jeweils hinsichtlich des Wertes und des beim Wert zusätzlich zu berücksichtigenden Vorzeichens bestimmt.

Im Verfahrensschritt S150 werden die Werte des ersten und zweiten linear-in-T-Systemfehler $k$ und $p$ bestimmt. Hierzu wird ausgenutzt, dass das Transmissionsverhalten in den beiden Transmissionspfaden der Messhalterung 4 jeweils reziprok ist. Somit gilt $e_{10} = e_{01}$ im einen Transmissionspfad und $e_{23} = e_{32}$ im anderen Transmissionspfad der Messhalterung.

Da sowohl der Transmissionskoeffizient $e_{01}$ in Vorwärtsrichtung des eines Transmissionspfades im Element $\tilde{E}_{2i}(1,1)$ der Systemfehlermatrix $\tilde{E}_{2i}$ als auch der Transmissionskoeffizient $e_{10}$ in Rückwärtsrichtung desselben Transmissionspfades im Element $\tilde{E}_{3i}(1,1)$ der Systemfehlermatrix $\tilde{E}_{3i}$ mit dem zweiten linear-in-T-Systemfehler $p$ gewichtet ist und zusätzlich zueinander reziprok sind ($e_{01} = e_{10}$), können die im letzten Verfahrensschritt S140 ermittelten Elemente $\tilde{E}_{2i}(1,1)$ und $\tilde{E}_{3i}(1,1)$ zur Ermittlung des Wertes des korrekten zweiten linear-in-T-Systemfehler $p_{kor}$ gemäß Gleichung (30A) unter Ausnutzung des Verhältnisfaktors $M$ zwischen den Elementen $\tilde{E}_{2i}(1,1)$ und $\tilde{E}_{3i}(1,1)$ gemäß Gleichung (27A) genutzt werden.

Da äquivalent der Transmissionskoeffizient $e_{23}$ in Vorwärtsrichtung des anderen Transmissionspfades der Messhalterung im Element $\tilde{E}_{2i}(2,2)$ der Systemfehlermatrix $\tilde{E}_{2i}$ als auch der Transmissionskoeffizient $e_{32}$ in Rückwärtsrichtung desselben Transmissionspfades im Element $\tilde{E}_{3i}(2,2)$ der Systemfehlermatrix $\tilde{E}_{3i}$ mit dem ersten linear-in-T-Systemfehler zueinander reziprok sind ($e_{23} = e_{32}$) und zusätzlich jeweils mit $k$ gewichtet sind, können die im letzten Verfahrensschritt S140 ermittelten Elemente $\tilde{E}_{2i}(2,2)$ und $\tilde{E}_{3i}(2,2)$ zur Ermittlung des Wertes des korrekten ersten linear-in-T-Systemfehler $k_{kor}$ gemäß Gleichung (30B) unter Ausnutzung des Verhältnisfaktors $M$ zwischen den Elementen $\tilde{E}_{2i}(2,2)$ und $\tilde{E}_{3i}(2,2)$ gemäß Gleichung (27B) genutzt werden.

Zur Bestimmung des beim Wert des korrekten ersten und korrekten zweiten linear-in-T-Systemfehlers $k_{kor}$ und $p_{kor}$ zusätzlich zu berücksichtigenden Vorzeichens im darauffolgenden Verfahrensschritt S160 werden äquivalent wie beim erfindungsgemäßen Verfahren zur Kalibrierung einer Messanordnung anhand eines 16-Term-Fehlermodells Plausibilitäten d.h. Zusammenhänge, zwischen der bekannten elektrischen Länge und dem zugehörigen Transmissionselementen in den Systemfehlermatrizen $\tilde{E}_{2i}$ und $\tilde{E}_{3i}$ des jeweiligen Transmissionspfads der Messhalterung 4 herangezogen. Auch hierbei muss die elektrische Länge nur auf $\pm 90°$ bekannt sein. Hierzu werden unter Berücksichtigung aller möglichen Vorzeichen die ermittelten Systemfehler-Matrizen $\tilde{T}_{1i}$ bis $\tilde{T}_{4i}$ nach Gleichung (31A) mit den korrekten ersten und korrekten zweiten linear-in-T-Systemfehlers $k_{kor}$ und $p_{kor}$ renormalisiert und aus den somit entstandenen Systemfehler-Matrizen $\tilde{T}_{1c}$ bis $\tilde{T}_{4c}$ in Anlehnung an die Gleichungen (22A) bis (22D) die zugehörigen Systemfehlermatrizen $\tilde{E}_{1c}$ bis $\tilde{E}_{4c}$ ermittelt. Anhand der so ermittelten Phasen der Transmissionskoeffizienten wird das korrekte Vorzeichen durch eine Plausibilitätsbetrachtung gewählt.

Im abschließenden Verfahrensschritt S170 werden die mit falschen Vorzeichen ermittelten Matrizen verworfen, so dass lediglich bereinigten Untermatrizen $\tilde{E}_{1c}$ bis $\tilde{E}_{4c}$ verbleiben. Diese bilden die korrekte Systemfehler-Matrix $\tilde{E}_c$ gemäß Gleichung (31B), die die Elemente zur Charakterisierung des Transmissions-, des Reflexions- und des Übersprechverhaltens der Messhalterung ohne einen verbleibenden Normalisierungsfaktor enthalten.

Im Folgenden wird die zweite Ausführungsform des erfindungsgemäßen Verfahrens zur Charakterisierung einer mit einem Netzwerkanalysator verbundenen Messhalterung anhand des Flussdiagrammes in Fig. 6B in Kombination mit dem erfindungsgemäßen System zur Charakterisierung einer mit einem Netzwerkanalysator verbundenen Messhalterung im Blockdiagramm der Fig. 4 im Detail erläutert.

Die Verfahrensschritte S200 bis S230 der zweiten Ausführungsform entsprechen den Verfahrensschritten S100 bis S130 der ersten Ausführungsform und werden deshalb an dieser Stelle nicht mehr wiederholt erläutert. In den nächsten Verfahrensschritten S240 und S250 wird das Verhältnis zwischen dem ersten und zweiten linear-in-T-Systemfehler $k$ und $p$ ermittelt.

Im Verfahrensschritt S240 wird der Wert des Verhältnisses zwischen dem ersten und zweiten linear-in-T-Systemfehler $k$ und $p$ ermittelt, indem die gemessenen Streuparameter des in der Messhalterung 4 fixierten fünften transmissionsbehafteten und reziproken Kalibrierstandards $R$ aus Gleichung (7E) benutzt werden. Äquivalent wie in Verfahrensschritt S40 des erfindungsgemäßen Verfahrens zur Kalibrierung einer Messanordnung anhand eines 16-Term-Fehlermodells werden die transformierten Transmissionskoeffizienten $\tilde{S}_{arez}(1,2)$ und $\tilde{S}_{arez}(2,1)$ des in der Messhalterung 4 fixierten transmissionsbehafteten und reziproken Kalibrierstandards $R$ gemäß Gleichung (16) aus den gemessene Streuparametern $S_{mrez}$ und den in Verfahrensschritt S230 ermittelten und von $p$ und $k$ abhängigen linear-in-T-System-Untermatrizen $\tilde{T}_{1i}$ bis $\tilde{T}_{4i}$ bestimmt. Der Wert für das Verhältnis zwischen dem zweiten linear-in-T-Systemfehler $p$ und dem ersten linear-in-T-Systemfehler $k$ lässt sich in Analogie zur Berechnung des korrekten zweiten linear-in-T-Systemfehlers $p_{kor}(k)$ in Abhängigkeit des frei gewählten ersten linear-in-T-Systemfehlers $k$ gemäß Gleichung (21) ermitteln. Da die Messhalterung 4 in beiden Transmissionspfaden ein reziprokes Transmissionsverhalten aufweist, gilt die Reziprozitätsbedingung des fünften transmissionsbehaften und reziproken Kalibrierstandards in der Referenzebene 2 auch bei der Messung in der Referenzebene 1.

Im nächsten Verfahrensschritt S250 wird das beim Wert des Verhältnisses zwischen dem ersten und zweiten linear-in-T-Systemfehler $k$ und $p$ zusätzlich zu berücksichtigende Vorzeichen äquivalent zum erfindungsgemäßen Verfahren zur Kalibrierung einer Messanordnung anhand eines 16-Term-Fehlermodells mittels Plausibilitätsüberlegungen, d.h. anhand von plausiblen Zusammenhängen, zwischen der elektrische Länge und den zueinander reziproken und gemäß Gleichung (16) transformierten Transmissionskoeffizienten $\tilde{S}_{arez}(1,2)$ und $\tilde{S}_{arez}(2,1)$ des in der Messhalterung 4 fixierten fünften Kalibrierstandards bestimmt.

Im darauffolgenden Verfahrensschritt S250 werden die in Verfahrensschritt S230 ermittelten linear-in-T-Systemfehler in den Untermatrizen $\widetilde{T_{1i}}$ bis $\widetilde{T_{4i}}$ der linear-in-T-Systemfehlermatrix $\tilde{T}_i$ äquivalent zu Verfahrensschritt S140 der ersten Ausführungsform mittels der Gleichungen (22A) bis (22D) in korrespondierende Systemfehler in den Untermatrizen $\widetilde{E_{1i}}$ bis $\widetilde{E_{4i}}$ der Systemfehlermatrix $\widetilde{E_i}$ transformiert.

Im darauffolgenden Verfahrensschritt S270 wird äquivalent zu Verfahrensschritt S150 der ersten Ausführungsform der Wert des korrekten ersten oder des korrekten zweiten linear-in-T-Systemfehlers $k_{kor}$ bzw. $p_{kor}$ anhand der Gleichung (30A) bzw. (30B) ermittelt, indem hierzu die Transmissionselemente $\tilde{E}_{2i}(1,1)$ und $\tilde{E}_{3i}(1,1)$ bzw. $\tilde{E}_{2i}(2,2)$ und $\tilde{E}_{3i}(2,2)$ der im vorherigen Verfahrensschritt S260 ermittelten Untermatrizen $\tilde{E}_{2i}$ und $\tilde{E}_{3i}$ der Systemfehlermatrix $\tilde{E}_i$ herangezogen werden.

Auch im nächsten Verfahrensschritt S280 wird äquivalent zu Verfahrensschritt S160 der ersten Ausführungsform das beim Wert des korrekten ersten linear-in-T-Systemfehlers $k_{kor}$ oder des korrekten zweiten linear-in-T-Systemfehlers $p_{kor}$ jeweils zusätzlich zu berücksichtigende Vorzeichen anhand von Plausibilitätsüberlegungen zwischen der elektrischen Länge und den beiden zueinander reziproken und in Verfahrensschritt S260 als Elemente einer Untermatrix der Systemfehlermatrix $\tilde{E}_i$ ermittelten Transmissionskoeffizienten eines Transmissionspfades der Messhalterung ermittelt.

Im darauffolgenden Verfahrensschritt S290 wird der jeweils andere korrekte - erste oder zweite - linear-in-T-Systemfehler $k_{kor}$ oder $p_{kor}$ anhand des in den Verfahrensschritten S240 und S250 jeweils ermittelten Wertes und beim Wert zusätzlich zu berücksichtigenden Vorzeichens des Verhältnisses zwischen ersten und zweiten linear-in-T-Systemfehler $k$ und $p$ und des in den vorherigen Verfahrensschritten S270 und S280 jeweils ermittelten Wertes und beim Wert zusätzlich zu berücksichtigenden Vorzeichens des ersten korrekten linear-in-T-Systemfehlers $k_{kor}$ oder des zweiten korrekten linear-in-T-Systemfehlers $p_{kor}$ bestimmt. Der abschließende Verfahrensschritt S295 entspricht dem Verfahrensschritt S170 in der ersten Ausführungsform und wird deshalb an dieser Stelle nicht wiederholt erläutert.

Sind nach der ersten und zweiten Ausführungsform des erfindungsgemäßen Verfahrens zur Charakterisierung einer mit einem Netzwerkanalysator verbundenen Messhalterung die einzelnen Elemente der Systemfehlermatrix $\tilde{E}_c$ bestimmt, so kann ein in der Messhalterung 4 fixiertes Messobjekt charakterisiert werden, indem die mit dem vektoriellen Netzwerkanalysator 1 in der Referenzebene 1 gemessenen Streuparameter $S_m$ mit den zu linear-in-T-Systemfehlern transformierten Elementen der ermittelten Systemfehlermatrix $\tilde{E}_c$ von den Systemfehlern des Netzwerkanalysators 1 und der Hochfrequenzmessleitungen $2_1$ und $2_2$ und von den Transmissions-, Reflexions- und Übersprecheinflüssen der Messhalterung 4 bereinigt werden. Dies entspricht einer Messung der Streuparameter des Messobjekts in der Referenzebene 2.

Aus Fig. 7 geht eine Messanordnung hervor, wie mithilfe eines vektoriellen Netzwerkanalysators 1 die Eignung des erfindungsgemäßen Verfahrens im Vergleich zu anderen Kalibrierverfahren für unterschiedliche Niveaus von Übersprechen an einem Messobjekt (engl. device-under-test (DUT)) 5 ermittelt werden kann. Das eingangsseitige und ausgangsseitige Übersprechen zwischen den eingangsseitigen Ports und zwischen den ausgangsseitigen Ports wird hierbei durch jeweils ein Dämpfungsglied $6_1$ und $6_2$ mit einstellbarem Dämpfungsfaktor zwischen den eingangsseitigen Ports sowie zwischen den ausgangsseitigen Ports simuliert. Hierbei wird der Dämpfungsgrad des Dämpfungsgliedes $6_1$ und $6_2$ variiert, um damit unterschiedliche Niveaus von Übersprechen zu simulieren.

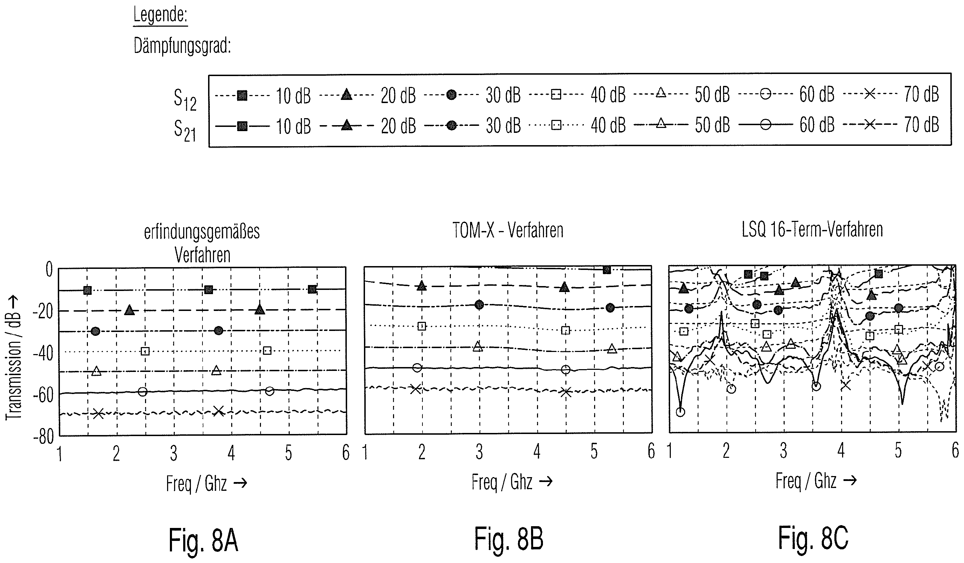

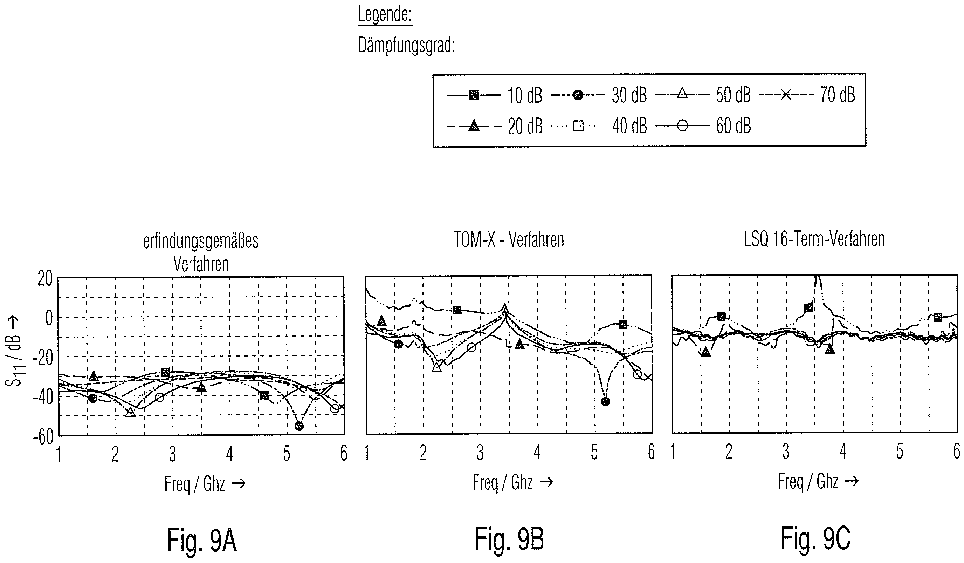

Aus den Figuren 8A bis 8C geht für ein eingestelltes Übersprechen in Höhe von -30 dB die Eignung des jeweiligen Verfahrens hinsichtlich der korrekten Messung des Transmissionsverhaltens bei mehreren Messobjekten mit jeweils unterschiedlichen Transmissionseigenschaften hervor, indem die mit der Messanordnung in Fig. 7 gemessenen Transmissionskoeffizienten $S_{12}$ und $S_{21}$ über dem Messfrequenzbereich dargestellt werden, während die Figuren 9A bis 9C die Eignung des jeweiligen Verfahren hinsichtlich der korrekten Messung des Reflexionsverhaltens bei mehreren Messobjekten mit jeweils unterschiedlichen Reflexionseigenschaften durch Darstellung des gemessenen Reflexionskoeffizienten $S_{11}$ über dem Messfrequenzbereich verdeutlichen.

Die Figuren 8A und 9A stellen die Messergebnisse dar, die das erfindungsgemäße Verfahren liefert, während in den Figuren 8B und 9B die Messergebnisse des zum Stand der Technik zählenden TOM-X-Verfahrens - die Buchstaben stehen für die dabei verwendeten Kalibrierstandards (Through = transmissionsbehaftet, Open = offen und Matched = angepasst) und für die Eignung, Übersprechen zu messen (X) - und in den Figuren 8C und 9C die Messergebnisse eines Verfahrens, das das 20x16-dimensionale Gleichungssystem nach einem Verfahren der kleinsten Fehlerquadrate löst. Dieses wird im Folgenden mit LSQ-16-Verfahren bezeichnet. Zu erkennen ist insbesondere die hohe Genauigkeit der Transmissionsmessung des erfindungsgemäßen Verfahrens gegenüber dem TOM-X-Verfahren und dem LSQ-16-Verfahren über den gesamten Messfrequenzbereich. Dabei wurde bei allen Verfahren derselbe Transmissionsstandard verwendet. Bei den dargestellten Ergebnissen wurde ein 3dB Dämpfungsglied als Transmissionsstandard eingesetzt.

An dieser Stelle wird darauf hingewiesen, dass zusätzliches Übersprechen fälschlicherweise durch numerische Ungenauigkeiten des bei der Lösung des linearen Gleichungssystems verwendeten Verfahrens im Fall von mit Rauschen überlagerten Messdaten entstehen kann. Diese nachteilige Einschränkung des Dynamikbereichs der Messung bei Verwendung eines 16-Term-Fehlermodells ist beim erfindungsgemäßen Verfahren gegenüber anderen Verfahren des Stands der Technik deutlich eingeschränkt.

Die erfindungsgemäßen Verfahren und die erfindungsgemäßen Systeme sind nicht auf die dargestellten Ausführungsformen beschränkt. Von der Erfindung sind insbesondere auch Messungen an Messobjekten und Messhalterungen mit mehr als zwei Toren abgedeckt, indem sequentiell für jeweils zwei Tore des Messobjekts bzw. der Messhalterung das erfindungsgemäße Verfahren angewendet wird. Von der Erfindung sind insbesondere die Kombinationen aller in den Patentansprüchen beanspruchten Merkmale, aller in der Beschreibung offenbarten Merkmale und aller in den Figuren der Zeichnung dargestellten Merkmale mit abgedeckt.

## Patentansprüche

1. Verfahren zur Kalibrierung eines Netzwerkanalysators (1) anhand eines Fehlermodells mit folgenden Verfahrensschritten:

   • Ermitteln einer Matrix ($A$) mit gemessenen Streuparametern ($S_m$) von verschiedenen Kalibrierstandards (3) und mit zugehörigen tatsächlichen Streuparametern ($S_a$) der Kalibrierstandards (3) und
   • Bestimmen von Systemfehlern ($\tilde{T}_i$) zur Kalibrierung des Netzwerkanalysators (1) mittels Lösen eines linearen Gleichungssystems mit der ermittelten Matrix ($A$),

   **dadurch gekennzeichnet,**
   **dass** zum Lösen des linearen Gleichungssystems ein erster und ein zweiter Systemfehler ($k, p$) jeweils frei gewählt werden und bei Verwendung eines reziproken und transmissionsbehafteten Kalibrierstandards die bestimmten Systemfehler
   mit dem frei gewählten ersten Systemfehler ($\tilde{T}_i$) oder mit einem vom ersten Systemfehler ($k$) abhängigen korrekten zweiten Systemfehler ($p_{kor}(k)$) gewichtet werden.

2. Verfahren nach Patentanspruch 1,
   **dadurch gekennzeichnet,**
   **dass** die verwendeten Kalibrierstandards (3) insgesamt vier transmissionslose Kalibrierstandards sind und/oder dass das Fehlermodell ein 16-Term-Fehlermodell ist.

3. Verfahren nach Patentanspruch 1 oder 2,
**dadurch gekennzeichnet,**
**dass** der Betrag des korrekten zweiten Systemfehlers ($p_{kor}(k)$) in Abhängigkeit des Betrags des ersten Systemfehlers ($k$) mittels einer Reziprozitätsbedingung ($\tilde{S}_{arez}(1,2) = \tilde{S}_{arez}(2,1)$) von systemfehlerbereinigten Transmissionsfaktoren ($\tilde{S}_{arez}(1,2),\tilde{S}_{arez}(2,1)$) eines transmissionsbehafteten und reziproken Kalibrierstandards (3) bestimmt wird.

4. Verfahren nach Patentanspruch 3,
**dadurch gekennzeichnet,**
**dass** die systemfehlerbereinigten Transmissionsfaktoren ($\tilde{S}_{arez}(1,2),\tilde{S}_{arez}(2,1)$) des transmissionsbehafteten reziproken Kalibrierstandards (3) mittels Transformation der gemessenen Transmissionsfaktoren ($S_{mrez}(1,2),S_{mrez}(2,1)$) des transmissionsbehafteten und reziproken Kalibrierstandards (3) mit den bestimmten Systemfehlern ($\tilde{T}_i$) erfolgt.

5. Verfahren nach einem der Patentansprüche 1 bis 4,
**dadurch gekennzeichnet,**
**dass** das Vorzeichens des korrekten zweiten Systemfehlers ($p_{kor}(k)$) in Abhängigkeit des Vorzeichens des ersten linear-in-T-Systemfehlers ($k$) mittels Zusammenhängen zwischen bekannten elektrischen Eigenschaften, bevorzugt der elektrischen Länge, eines transmissionsbehafteten Kalibrierstandards (3) und systemfehlerbereinigten und reziproken Transmissionsfaktoren ($\tilde{S}_{arez}(1,2),\tilde{S}_{arez}(2,1)$) des transmissionsbehafteten und reziproken Kalibrierstandards (3) bestimmt wird.

6. Verfahren zur Charakterisierung einer mit einem Netzwerkanalysator (1) verbundenen Messhalterung (4) anhand eines Fehlermodells mit folgenden Verfahrensschritten:

  • Ermitteln einer Matrix ($A$) mit gemessenen Streuparametern ($S_m$) von verschiedenen in der Messhalterung (4) jeweils fixierten Kalibrierstandards (3) und mit zugehörigen tatsächlichen Streuparametern ($S_a$) der Kalibrierstandards (3),
  • Bestimmen von Systemfehlern ($\tilde{T}_i$) des Fehlermodells mittels Lösen eines linearen Gleichungssystems mit der ermittelten Matrix ($A$) und
  • Transformieren der Systemfehler ($\tilde{T}_i$) in korrespondierende Systemfehler einer Systemfehlermatrix ($\tilde{E}_i$) des Fehlermodells, die die Messhalterung (4) charakterisieren,

  **dadurch gekennzeichnet,**
  **dass** zum Lösen des linearen Gleichungssystems ein erster und ein zweiter Systemfehler ($k, p$) jeweils frei gewählt werden und bei Verwendung eines reziproken und transmissionsbehafteten Kalibrierstandards (3) die bestimmten Systemfehler der Systemfehlermatrix ($\tilde{E}_i$) mit einem korrekten ersten Systemfehler ($k_{kor}$) oder mit einem korrekten zweiten Systemfehler ($p_{kor}$) gewichtet werden.

7. Verfahren nach Patentanspruch 6,
**dadurch gekennzeichnet,**
**dass** die Messhalterung (4) hinsichtlich ihrer Transmission reziprok ist.

8. Verfahren nach Patentanspruch 6 oder 7,
**dadurch gekennzeichnet,**
**dass** die verwendeten Kalibrierstandards (3) insgesamt vier transmissionslose Kalibrierstandards sind und/oder dass das Fehlermodell ein 16-Term-Fehlermodell ist.

9. Verfahren nach einem der Patentansprüche 6 bis 8,
**dadurch gekennzeichnet,**
**dass** der Betrag des korrekten ersten und korrekten zweiten Systemfehlers ($k_{kor}, p_{kor}$) jeweils mittels einer Reziprozitätsbedingung zwischen zwei zueinander reziproken Transmissionskoeffizienten ($\tilde{E}_{2i}(1,1),\tilde{E}_{3i}(1,1);$ $\tilde{E}_{2i}(2,2),\tilde{E}_{3i}(2,2)$) eines Transmissionspfades der Messhalterung (4) in der Systemfehlerfehlermatrix ($\tilde{E}_i$) bei Fixierung eines transmissionsbehafteten reziproken Kalibrierstandards (3) in der Messhalterung (4) bestimmt wird.

10. Verfahren nach einem der Patentansprüche 6 bis 8,
**dadurch gekennzeichnet,**
**dass** das Vorzeichens des korrekten ersten und korrekten zweiten Systemfehlers ($k_{kor}, p_{kor}$) jeweils unter Ausnutzung von Zusammenhängen zwischen bekannten elektrischen Eigenschaften, bevorzugt der elektrischen Länge, und zwei zueinander reziproken Transmissionskoeffizienten ($\tilde{E}_{2i}(1,1),\tilde{E}_{3i}(1,1);$ $\tilde{E}_{2i}(2,2),\tilde{E}_{3i}(2,2)$) eines Transmissi-

onspfades der Messhalterung (4) in der Systemfehlerfehlermatrix ($\tilde{E}_i$) bei Fixierung eines transmissionsbehafteten und reziproken Kalibrierstandards (3) in der Messhalterung (4) bestimmt wird.

11. Verfahren nach einem der Patentansprüche 6 bis 8,
**dadurch gekennzeichnet,**
**dass** der Betrag des Verhältnisses zwischen erstem und zweitem Systemfehler ($k$, $p$) mittels einer Reziprozitäts-bedingung ($\tilde{S}_{arez}(1,2) = \tilde{S}_{arez}(2,1)$) von systemfehlerbereinigten Transmissionsfaktoren ($\tilde{S}_{arez}(1,2), \tilde{S}_{arez}(2,1)$) eines in der Messhalterung (4) fixierten transmissionsbehafteten und reziproken Kalibrierstandards (3) bestimmt wird.

12. Verfahren nach Patentanspruch 11,
**dadurch gekennzeichnet,**
**dass** die systemfehlerbereinigten Transmissionsfaktoren ($\tilde{S}_{arez}(1,2), \tilde{S}_{arez}(2,1)$) des in der Messhalterung (4) fixierten transmissionsbehafteten und reziproken Kalibrierstandards (3) mittels Transformation von gemessenen Transmissionsfaktoren ($S_{mrez}(1,2), S_{mrez}(2,1)$) des in der Messhalterung (4) fixierten transmissionsbehafteten und reziproken Kalibrierstandards (3) mit den bestimmten Systemfehlern ($\tilde{T}_i$) erfolgt.

13. Verfahren nach einem der Patentansprüche 6 bis 8, 11 oder 12,
**dadurch gekennzeichnet,**
**dass** das Vorzeichen des Verhältnisses zwischen ersten und zweiten Systemfehler ($k$, $p$) unter Ausnutzung von Zusammenhängen zwischen bekannten elektrischen Eigenschaften, bevorzugt der elektrischen Länge, und sys-temfehlerbereinigten Transmissionsfaktoren ($\tilde{S}_{arez}(1,2), \tilde{S}_{arez}(2,1)$) des in der Messhalterung (4) fixierten transmissionsbehafteten und reziproken Kalibrierstandards (3) bestimmt wird.

14. Verfahren nach einem der Patentansprüche 6 bis 8 oder 11 bis 13,
**dadurch gekennzeichnet,**
**dass** der Betrag entweder des korrekten ersten oder des korrekten zweiten Systemfehlers ($k_{kor}$, $p_{kor}$) jeweils mittels einer Reziprozitätsbedingung zwischen zwei zueinander reziproken Transmissionskoeffizienten ($\tilde{E}_{2i}(1,1), \tilde{E}_{3i}(1,1)$; $\tilde{E}_{2i}(2,2), \tilde{E}_{3i}(2,2)$) eines Transmissionspfades der Messhalterung (4) in der Systemfehlermatrix ($\tilde{E}_i$) bei Fixierung eines transmissionsbehafteten und reziproken Kalibrierstandards (3) in der Messhalterung (4) bestimmt wird.

15. Verfahren nach einem der Patentansprüche 6 bis 8 oder 11 bis 13,
**dadurch gekennzeichnet,**
**dass** das Vorzeichen entweder des korrekten ersten oder des korrekten zweiten Systemfehlers ($k_{kor}$, $p_{kor}$) jeweils mittels Zusammenhängen zwischen bekannten elektrischen Eigenschaften, bevorzugt der elektrischen Länge, und zwei zueinander reziproken Transmissionskoeffizienten ($\tilde{E}_{2i}(1,1), \tilde{E}_{3i}(1,1)$; $\tilde{E}_{2i}(2,2), \tilde{E}_{3i}(2,2)$) eines Transmissions-pfades der Messhalterung (4) in der Systemfehlermatrix ($\tilde{E}_i$) bei Fixierung eines transmissionsbehafteten und reziproken Kalibrierstandards (3) in der Messhalterung (4) bestimmt wird.

16. Verfahren nach Patentanspruch 15,
**dadurch gekennzeichnet,**
**dass** der Betrag und das Vorzeichen des jeweils anderen korrekten ersten oder korrekten zweiten Systemfehlers ($k_{kor}$, $p_{kor}$) anhand des ermittelten Betrages und des ermittelten Vorzeichens des ersten bzw. des zweiten System-fehlers ($k_{kor}$, $p_{kor}$) und des ermittelten Betrages und des ermittelten Vorzeichens des Verhältnisses zwischen ersten und zweiten Systemfehler $(k, p)$ bestimmt werden.

17. Verfahren nach einem der Patentansprüche 6 bis 16,
**dadurch gekennzeichnet,**
**dass** vorab vom Netzwerkanalysator und von Messleitungen verursachte Systemfehler mittels Kalibrierung ermittelt werden und die gemessenen Streuparameter ($S_m$) von verschiedenen in der Messhalterung (4) jeweils fixierten Kalibrierstandards (3) von den vorab ermittelten Systemfehlern bereinigt werden.

18. System zur Kalibrierung eines Netzwerkanalysators (1) anhand eines Fehlermodells mit verschiedenen Kalibrierstandards (3), wobei das System dafür konfiguriert ist, das Verfahren des Anspruch 1 durchzuführen.

19. System zur Charakterisierung einer mit einem Netzwerkanalysator (1) verbundenen Messhalterung (4) anhand eines Fehlermodells, wobei das System dafür konfiguriert ist, das Verfahren des Anspruch 6 durchzuführen.

20. System nach Anspruch 18 oder 19,

**dadurch gekennzeichnet,**
**dass** die verwendeten Kalibrierstandards (3) insgesamt vier transmissionslose Kalibrierstandards sind.

21. System nach einem der Ansprüche 18 bis 20,
**dadurch gekennzeichnet,**
**dass** das Fehlermodell ein 16-Term-Fehlermodell ist.

**Claims**

1. Method for calibration of a network analyser (1) with reference to an error model with the following method steps:

   • Determination of a matrix ($A$) with measured scattering parameters ($S_m$) of different calibration standards (3) and with associated actual scattering parameters ($S_a$) of the calibration standards (3) and
   • Definition of system errors ($\tilde{T_i}$) for calibration of the network analyser (1) by solving a linear equation system with the determined matrix ($A$),

   **characterised in that**
   to solve the linear equation system, a first and a second system error ($k, p$) are each selected freely and using a reciprocal and transmission-affected calibration standard the defined system errors are weighted with the freely selected first system error ($\tilde{T_i}$) or with a correct second system error ($p_{kor}(k)$) dependent on the first system error ($k$).

2. Method according to patent claim 1,
   **characterised in that**
   the calibration standards (3) used are in all four transmission-less calibration standards and/or **in that** the error model is a 16-term error model.

3. Method according to patent claim 1 or 2,
   **characterised in that**
   the amount of the correct second system error ($p_{kor}(k)$) dependent on the amount of the first system error ($k$) is defined by means of a reciprocity condition ($\tilde{S}_{arez}(1,2) = \tilde{S}_{arez}(2,1)$) from system error-corrected transmission factors ($\tilde{S}_{arez}(1,2), \tilde{S}_{arez}(2,1)$) of a transmission-affected and reciprocal calibration standard (3).

4. Method according to patent claim 3,
   **characterised in that**
   the system error-corrected transmission factors ($\tilde{S}_{arez}(1,2), \tilde{S}_{arez}(2,1)$) of the transmission-affected reciprocal calibration standard (3) are obtained by means of transformation of the measured transmission factors ($S_{mrez}(1,2), S_{mrez}(2,1)$) of the transmission-affected and reciprocal calibration standard (3) with the defined system errors ($\tilde{T_i}$).

5. Method according to one of patent claims 1 to 4,
   **characterised in that**
   the sign of the correct second system error ($p_{kor}(k)$) dependent on the sign of the first linear-in-T system error ($k$) is defined by means of relationships between known electrical properties, preferably the electrical length, of a transmission-affected calibration standard (3) and system error-corrected and reciprocal transmission factors ($\tilde{S}_{arez}(1,2), \tilde{S}_{arez}(2,1)$) of the transmission-affected and reciprocal calibration standard (3).

6. Method for characterisation of a measuring fixture (4) connected with a network analyser (1) with reference to an error model with the following method steps:

   • Determination of a matrix ($A$) with measured scattering parameters ($S_m$) of different calibration standards (3) in each case fixed in the measuring fixture (4) and with associated actual scattering parameters ($S_a$) of the calibration standards (3),
   • Definition of system errors ($\tilde{T_i}$) of the error model by solving a linear equation system with the determined matrix ($A$) and
   • Transformation of the system errors ($\tilde{T_i}$) into corresponding system errors of a system error matrix ($\tilde{E_i}$) of the error model which characterise the measuring fixture (4),

**characterised in that**
to solve the linear equation system, a first and a second system error ($k,p$) are each selected freely and using a reciprocal and transmission-affected calibration standard (3) the defined system errors of the system error matrix ($\tilde{E}_i$) are weighted with a correct first system error ($k_{kor}$) or with a correct second system error ($p_{kor}$).

7.  Method according to patent claim 6,
    **characterised in that**
    the measuring fixture (4) is reciprocal with respect to its transmission.

8.  Method according to patent claim 6 or 7,
    **characterised in that**
    the calibration standards (3) used are in all four transmission-less calibration standards and/or **in that** the error model is a 16-term error model.

9.  Method according to one of patent claims 6 to 8,
    **characterised in that**
    the amount of the correct first and correct second system error ($k_{kor},p_{kor}$) is in each case defined by means of a reciprocity condition between two mutually reciprocal transmission coefficients ($\tilde{E}_{2i}(1,1),\tilde{E}_{3i}(1,1);\tilde{E}_{2i}(2,2),\tilde{E}_{3i}(2,2)$) of a transmission path of the measuring fixture (4) in the system error matrix ($\tilde{E}_i$) when a transmission-affected reciprocal calibration standard (3) is fixed in the measuring fixture (4).

10. Method according to one of patent claims 6 to 8,
    **characterised in that**
    the sign of the correct first and correct second system error ($k_{kor},p_{kor}$) is in each case defined using relationships between known electrical properties, preferably the electrical length, and two mutually reciprocal transmission co-efficients ($\tilde{E}_{2i}(1,1),\tilde{E}_{3i}(1,1);\tilde{E}_{2i}(2,2),\tilde{E}_{3i}(2,2)$) of a transmission path of the measuring fixture (4) in the system error matrix ($\tilde{E}_i$) when a transmission-affected and reciprocal calibration standard (3) is fixed in the measuring fixture (4).

11. Method according to one of patent claims 6 to 8,
    **characterised in that**
    the amount of the ratio between the first and the second system error ($k,p$) is defined by means of a reciprocity condition ($\tilde{S}_{arez}(1,2) = \tilde{S}_{arez}(2,1)$) from system error-corrected transmission factors ($\tilde{S}_{arez}(1,2),\tilde{S}_{arez}(2,1)$) of a transmission-affected and reciprocal calibration standard (3) fixed in the measuring fixture (4).

12. Method according to patent claim 11,
    **characterised in that**
    the system error-corrected transmission factors ($\tilde{S}_{arez}(1,2),\tilde{S}_{arez}(2,1)$) of the transmission-affected and reciprocal calibration standard (3) fixed in the measuring fixture (4) are obtained by means of transformation of measured transmission factors ($S_{mrez}(1,2),S_{mrez}(2,1)$) of the transmission-affected and reciprocal calibration standard (3) fixed in the measuring fixture (4) with the defined system errors ($\tilde{T}_i$).

13. Method according to one of patent claims 6 to 8, 11 or 12,
    **characterised in that**
    the sign of the ratio between the first and the second system error ($k,p$) is defined using relationships between known electrical properties, preferably the electrical length, and system error-corrected transmission factors ($\tilde{S}_{arez}(1,2),\tilde{S}_{arez}(2,1)$) of the transmission-affected and reciprocal calibration standard (3) fixed in the measuring fixture (4).

14. Method according to one of patent claims 6 to 8 or 11 to 13,
    **characterised in that**
    the amount of either the correct first or the correct second system error ($k_{kor},p_{kor}$) is in each case defined by means of a reciprocity condition between two mutually reciprocal transmission coefficients ($\tilde{E}_{2i}(1,1),\tilde{E}_{3i}(1,1);\tilde{E}_{2i}(2,2),\tilde{E}_{3i}(2,2)$) of a transmission path of the measuring fixture (4) in the system error matrix ($\tilde{E}_i$) when a transmission-affected and reciprocal calibration standard (3) is fixed in the measuring fixture (4).

15. Method according to one of patent claims 6 to 8 or 11 to 13,
    **characterised in that**
    the sign of either the correct first or the correct second system error ($k_{kor}, p_{kor}$) is in each case defined by means of relationships between known electrical properties, preferably the electrical length, and two mutually reciprocal transmission coefficients ($\tilde{E}_{2i}(1,1),\tilde{E}_{3i}(1,1);\tilde{E}_{2i}(2,2),\tilde{E}_{3i}(2,2)$) of a transmission path of the measuring fixture (4) in the system error matrix ($\tilde{E}_i$) when a transmission-affected and reciprocal calibration standard (3) is fixed in the measuring fixture (4).

16. Method according to patent claim 15,
**characterised in that**
the amount and the sign of the in each case other correct first or correct second system error ($k_{kor}$, $p_{kor}$) are defined with reference to the determined amount and the determined sign of the first and the second system error ($k_{kor}$, $p_{kor}$) respectively and the determined amount and the determined sign of the ratio between the first and the second system error ($k, p$).

17. Method according to one of patent claims 6 to 16,
**characterised in that**
initially system errors caused by the network analyser and by measuring lines are determined by means of calibration and the measured scattering parameters ($S_m$) of different calibration standards (3) in each case fixed in the measuring fixture (4) are corrected by eliminating the system errors determined initially.

18. System for calibration of a network analyser (1) with reference to an error model with different calibration standards (3), wherein the system is configured to implement the method of claim 1.

19. System for characterisation of a measuring fixture (4) connected with a network analyser (1) with reference to an error model, wherein the system is configured to implement the method of claim 6.

20. System according to claim 18 or 19,
**characterised in that**
the calibration standards (3) used are in all four transmission-less calibration standards.

21. System according to one of claims 18 to 20,
**characterised in that**
the error model is a 16-term error model.

**Revendications**

1. Procédé d'étalonnage d'un analyseur de réseau (1) sur la base d'un modèle d'erreur, comprenant les étapes de procédé suivantes :

  - la détermination d'une matrice (*A*) au moyen de paramètres de dispersion ($S_m$) de différents étalons (3) et de paramètres de dispersion ($S_a$) effectifs associés des étalons (3) et
  - la détermination d'erreurs système ($\tilde{T}i$) pour l'étalonnage de l'analyseur de réseau (1) par résolution d'un système d'équations linéaires au moyen de la matrice (*A*) déterminée,

  **caractérisé en ce que,**
  pour résoudre le système d'équations linéaires, une première et une deuxième erreur système ($k, p$) sont chacune sélectionnées librement et, lors de l'utilisation d'un étalon réciproque et soumis à transmission, les erreurs système sont pondérées au moyen de la première erreur système ($\tilde{T}i$) sélectionnée librement ou d'une deuxième erreur système correcte ($p_{kor}(k)$) dépendant de la première erreur système ($k$).

2. Procédé selon la revendication 1,
**caractérisé en ce que,**
les étalons (3) utilisés sont au total quatre étalons sans transmission et/ou **en ce que** le modèle d'erreur est un modèle d'erreur à 16 termes.

3. Procédé selon la revendication 1 ou 2,
**caractérisé en ce que,**
la valeur de la deuxième erreur système correcte ($p_{kor}(k)$) est déterminée en fonction de la valeur de la première erreur système ($k$) au moyen d'une condition de réciprocité ($\tilde{S}_{arez}(1,2) = (\tilde{S}_{arez}(2,1)$ de facteurs de transmission

($\tilde{S}_{arez}$(1,2),($\tilde{S}_{arez}$(2,1), débarrassés des erreurs système, d'un étalon (3) avec transmission et réciproque.

4. Procédé selon la revendication 3,
   **caractérisé en ce que,**
   les facteurs de transmission ($\tilde{S}_{arez}$(1,2),($\tilde{S}_{arez}$(2,1) débarrassés des erreurs système, de l'étalon (3) avec transmission et réciproque s'effectuent par transformation des facteurs de transmission ($S_{mrez}$(1,2),$S_{mrez}$(2,1)) mesurés de l'étalon (3) avec transmission et réciproque au moyen des erreurs système ($\tilde{T}i$) déterminées.

5. Procédé selon l'une quelconque des revendications 1 à 4,
   **caractérisé en ce que,**
   le signe de la deuxième erreur système correcte ($p_{kor}$(k)) est déterminé en fonction du signe de la première erreur système linéaire en $T(k)$ par corrélation entre des propriétés électriques connues, de préférence la longueur électrique, d'un étalon (3) avec transmission et de facteurs de transmission ($\tilde{S}_{arez}$(1,2),($\tilde{S}_{arez}$(2,1) débarrassés des erreurs système et réciproques, de l'étalon (3) avec transmission et réciproque.

6. Procédé de caractérisation d'un support de mesure (4) relié à l'analyseur de réseau (1) sur la base d'un modèle d'erreur, comprenant les étapes de procédé suivantes :

   - la détermination d'une matrice ($A$) au moyen de paramètres de dispersion ($S_m$) mesurés de différents étalons (3) respectivement fixés dans le support de mesure (4) et de paramètres de dispersion ($S_a$) effectifs associés des étalons (3),
   - la détermination d'erreurs système ($\tilde{T}i$) du modèle d'erreur par résolution d'un système d'équations linéaires au moyen de la matrice ($A$) déterminée et
   - la transformation des erreurs système ($\tilde{T}i$) dans les erreurs système correspondantes d'une matrice d'erreurs système ($\tilde{E}i$) du modèle d'erreur, qui caractérisent le support de mesure (4),

   **caractérisé en ce que,**
   pour résoudre le système d'équations linéaires, une première et une deuxième erreur système ($k, p$) sont chacune sélectionnées librement et, lors de l'utilisation d'un étalon (3) réciproque et avec transmission, les erreurs système déterminées de la matrice d'erreurs système ($\tilde{E}i$) sont pondérées au moyen d'une première erreur système correcte ($k_{kor}$) ou d'une deuxième erreur système correcte ($p_{kor}$).

7. Procédé selon la revendication 6,
   **caractérisé en ce que,**
   le support de mesure (4) est réciproque en ce qui concerne sa transmission.

8. Procédé selon la revendication 6 ou 7,
   **caractérisé en ce que,**
   les étalons (3) utilisés sont au total quatre étalons sans transmission et/ou **en ce que** le modèle d'erreur est un modèle d'erreur à 16 termes.

9. Procédé selon l'une quelconque des revendications 6 à 8,
   **caractérisé en ce que,**
   la valeur de la première erreur système correcte et de la deuxième erreur système correcte ($k_{kor}, p_{kor}$) est déterminée respectivement au moyen d'une condition de réciprocité entre deux coefficients de transmission ($\tilde{E}_{2i}$(1,1),$\tilde{E}_{3i}$(1,1); $\tilde{E}_{2i}$(2,2),$\tilde{E}_{3i}$(2,2) d'un trajet de transmission du support de mesure (4) dans la matrice d'erreurs système ($\tilde{E}i$) lors de la fixation d'un étalon (3) réciproque et avec transmission dans le support de mesure (4).

10. Procédé selon l'une quelconque des revendications 6 à 8,
    **caractérisé en ce que,**
    le signe de la première erreur système correcte et de la deuxième erreur système correcte ($k_{kor}, p_{kor}$) est déterminé respectivement en utilisant une corrélation entre des propriétés électriques connues, de préférence la longueur électrique, et deux coefficients de transmission ($\tilde{E}_{2i}$(1,1),$\tilde{E}_{3i}$(1,1); $\tilde{E}_{2i}$(2,2),$\tilde{E}_{3i}$(2,2) mutuellement réciproques d'un trajet de transmission du support de mesure (4) dans la matrice d'erreurs système ($\tilde{E}i$) lors de la fixation d'un étalon (3) réciproque et avec transmission dans le support de mesure (4).

11. Procédé selon l'une quelconque des revendications 6 à 8,
    **caractérisé en ce que,**

la valeur du rapport entre la première et la deuxième erreur système correcte (k, p) est déterminée au moyen d'une condition de réciprocité ($\tilde{S}_{arez}(1,2) = \tilde{S}_{arez}(2,1)$) de facteurs de transmission ($\tilde{S}_{arez}(1,2)$, $\tilde{S}_{arez}(2,1)$) débarrassés des erreurs système, d'un étalon (3) avec transmission et réciproque fixé dans le support de mesure (4).

**12.** Procédé selon la revendication 11,
**caractérisé en ce que,**
les facteurs de transmission ($\tilde{S}_{arez}(1,2)$, $\tilde{S}_{arez}(2,1)$) débarrassés des erreurs système, de l'étalon (3) avec transmission et réciproque fixé dans le support de mesure (4), s'effectuent par transformation des facteurs de transmission ($S_{mrez}(1,2)$, $S_{mrez}(2,1)$) mesurés de l'étalon (3) avec transmission et réciproque fixé dans le support de mesure (4) au moyen des erreurs système ($\tilde{T}i$) déterminées.

**13.** Procédé selon l'une quelconque des revendications 6 à 8, 11 ou 12,
**caractérisé en ce que,**
le signe du rapport entre la première et la deuxième erreur système ($k, p$) est déterminé en utilisant une corrélation entre des propriétés électriques connues, de préférence la longueur électrique, et les facteurs de transmission ($\tilde{S}_{arez}(1,2)$, $\tilde{S}_{arez}(2,1)$) débarrassés des erreurs système, de l'étalon (3) avec transmission et réciproque fixé dans le support de mesure (4).

**14.** Procédé selon l'une quelconque des revendications 6 à 8 ou 11 à 13,
**caractérisé en ce que,**
la valeur soit de la première erreur système correcte soit de la deuxième erreur système correcte ($k_{kor}$, $p_{kor}$) est déterminée respectivement au moyen d'une condition de réciprocité entre deux coefficients de transmission ($\tilde{E}_{2i}(1,1)$, $\tilde{E}_{3i}(1,1)$; $\tilde{E}_{2i}(2,2)$, $\tilde{E}_{3i}(2,2)$) mutuellement réciproques d'un trajet de transmission du support de mesure (4) dans la matrice d'erreurs système ($\tilde{E}i$) lors de la fixation d'un étalon (3) réciproque et avec transmission dans le support de mesure (4).

**15.** Procédé selon l'une quelconque des revendications 6 à 8 ou 11 à 13,
**caractérisé en ce que,**
le signe soit de la première erreur système correcte soit de la deuxième erreur système correcte ($k_{kor}$, $p_{kor}$) est déterminé respectivement au moyen d'une corrélation entre des propriétés électriques connues, de préférence la longueur électrique, et deux coefficients de transmission ($\tilde{E}_{2i}(1,1)$, $\tilde{E}_{3i}(1,1)$; $\tilde{E}_{2i}(2,2)$, $\tilde{E}_{3i}(2,2)$) mutuellement réciproques d'un trajet de transmission du support de mesure (4) dans la matrice d'erreurs système ($\tilde{E}i$) lors de la fixation d'un étalon (3) réciproque et avec transmission dans le support de mesure (4).

**16.** Procédé selon la revendication 15,
**caractérisé en ce que,**
la valeur et le signe de l'autre première erreur système correcte ou deuxième erreur système correcte ($k_{kor}$, $p_{kor}$) sont déterminés sur la base de la valeur déterminée et du signe déterminé de la première ou de la deuxième erreur système ($k_{kor}$, $p_{kor}$) et de la valeur déterminée et du signe déterminé du rapport entre la première et la deuxième erreur système ($k, p$).

**17.** Procédé selon l'une quelconque des revendications 6 à 16,
**caractérisé en ce que,**
au préalable, les erreurs système provoquées par l'analyseur de réseau et des lignes de mesure sont déterminées au moyen d'un étalonnage et les paramètres de dispersion ($S_m$) mesurés d'étalons (3) différents respectivement fixés dans le support de mesure (4) sont débarrassés des erreurs système préalablement déterminées.

**18.** Système d'étalonnage d'un analyseur de réseau (1) sur la base d'un modèle d'erreur comprenant des étalons (3) différents, dans lequel le système est configuré pour mettre en oeuvre le procédé selon la revendication 1.

**19.** Système de caractérisation d'un support de mesure (4) relié à un analyseur de réseau (1) sur la base d'un modèle d'erreur, dans lequel le système est configuré pour mettre en oeuvre le procédé selon la revendication 6.

**20.** Système selon la revendication 18 ou 19,
**caractérisé en ce que,**
les étalons (3) utilisés sont au total quatre étalons sans transmission.

**21.** Système selon l'une quelconque des revendications 18 à 20,

**caractérisé en ce que,**
le modèle d'erreur est un modèle d'erreur à 16 termes.

Fig. 1

Fig. 2

Fig. 3

Fig. 4

Fig. 7

Start

Messen der Streuparameter von insgesamt vier transmissionslosen Kalibrierstandards und einem transmissionsbehafteten Kalibrierstandard — S10

Aufstellen eines linearen Gleichungssystems mit einer Matrix aus den gemessenen und den tatsächlichen Streuparametern der transmissionslosen Kalibrierstandards und einem Vektor aus 14 unbestimmten Linear-in-T-Systemfehlern und zwei frei gewählten Linear-in-T-Systemfehlern — S20

Bestimmen der 14 Linear-in-T-Systemfehlern in Abhängigkeit der beiden frei gewählten Linear-in-T-Systemfehler mittels Lösen des linearen Gleichungssystems — S30

Ermitteln des Werts des zweiten, ursprünglich frei gewählten Linear-in-T-Systemfehler in Abhängigkeit des ersten frei gewählten Linear-in-T-Systemfehler durch Ausnutzung der Reziprozitätsbedingung zwischen den gemessenen Transmissionskoeffizienten des transmissionsbehafteteten, reziproken Kalibrierstandards — S40

Ermitteln des beim Wert zusätzlich zu berücksichtigenden Vorzeichens des zweiten Linear-in-T-Systemfehlers in Abhängigkeit des ersten Linear-in-T-Systemfehlers aufgrund von Plausibilitäten zwischen der elektrischen Länge und den transformierten Transmissionskoeffizienten des transmissionsbehafteten, reziproken Kalibrierstandards — S50

Bestimmen von 14 korrekten Linear-in-T-Systemfehlern mittels Gewichten der aus den linearen Gleichungssystem ermittelten 14 Linear-in-T-Systemfehlern mit dem ersten oder dem zweiten Linear-in-T-Systemfehler — S60

Ende

Fig. 5

Fig. 6A

Start

Ermitteln der durch Netzwerkanalysator und Messleitung verursachten Systemfehler mittels Kalibrierung — S200

Messen der Streuparameter in der Referenzebene 1 und Bereinigen der mittels Kalibrierung ermittelten Systemfehler in den gemessenen Streuparametern — S210

Aufstellen eines linearen Gleichungssystems mit den systemfehlerbereinigten Streuparametern in Referenzebene 1 und den tatsächlichen Streuparametern der verwendeten Kalibrierstandards, 2 frei gewählten und 14 zu bestimmenden Linear-in-T-Systemfehlern — S220

Bestimmen der 14 Linear-in-T-Systemfehler in Abhängigkeit der 2 frei gewählten Linear-in-T-Systemfehler mttels Lösen des linearen Gleichungssystems — S230

Ermitteln des Werts des Verhältnisses zwischen ersten und zweiten Linear-in-T-Systemfehler mittels Reziprozitätsbedingung zwischen zwei reziproken, transformierten Transmissions-koeffizenten eines in der Messhalterung fixierten transmissionsbehafteten Kalibrierstandards — S240

Ermitteln des beim Wert zusätzlich zu berücksichtigenden Vorzeichens des Verhältnisses zwischen ersten und zweiten Linear-in-T-Systemfehler aufgrund von Plausibilitäten zwischen elektrischer Länge und den transformierten Transmissionskoeffizenten des transmissionsbehafteten Kalibrierstandards — S250

Transformieren der Elemente der T-Matrizen in Elemente der E-Matrizen — S260

Ermitteln des Werts des korrekten ersten und zweiten Linear-in-T-Systemfehlers mittels Reziprozitäts-bedingung zwischen zwei zueinander reziproken Transmissionselemente der E-Matrizen eines Transmissionspfades der Messhalterung bei in der Messhalterung fixierten trans-missionsbehafteten, reziproken Kalibrierstandard — S270

Ermitteln des beim Wert zusätzlich zu berücksichtigenden Vorzeichens des korrekten ersten und zweiten korrekten Linear-in-T-Systemfehlers aufgrund von Plausibilitäten zwischen elektrischer Länge und dem ermittelten Transmissionskoeffizenten eines Transmissionspfades der Messhalterung — S280

Ermitteln der jeweils anderen korrekten ersten oder zweiten Linear-in-T-Systemfehlers aus den bereits ermittelten korrekten ersten oder zweiten Linear-in-T-Systemfehlers und dem ermittelten Verhältnis zwischen ersten und zweiten Linear-in-T-Systemfehler — S290

Bestimmen der einzelnen Systemfehler der E-Matrizen in Abhängigkeit der ermittelten korrekten ersten und zweiten Linear-in-T-Systemfehler, die Transmission, Reflexion und Übersprechen in der Messhalterung beschreiben — S295

Fig. 6B

Ende

Legende:
Dämpfungsgrad:

$S_{12}$ · · ■ · · 10 dB  · · ▲ · · 20 dB  · · ☐ · · 30 dB  · · ● · · 40 dB  · · △ · · 50 dB  · · ○ · · 60 dB  · · ✕ · · 70 dB

$S_{21}$ —■— 10 dB  —▲— 20 dB  —☐— 30 dB  —●— 40 dB  —△— 50 dB  —○— 60 dB  —✕— 70 dB

erfindungsgemäßes Verfahren

Freq / Ghz →

Fig. 8A

TOM-X - Verfahren

Freq / Ghz →

Fig. 8B

LSQ 16-Term-Verfahren

Freq / Ghz →

Fig. 8C

← Transmission / dB

Fig. 9A

Fig. 9B

Fig. 9C

| Nummer | Std 1 | Std 2 | Std 3 | Std 4 |
|--------|-------|-------|-------|-------|
| 1 | MO | MS | OO | SM |
| 2 | MO | MS | OS | SM |
| 3 | MO | MS | OM | SO |
| 4 | MO | MS | OM | SS |
| 5 | MO | MM | OO | SS |
| 6 | MO | MM | OS | SO |
| 7 | MO | MM | OS | SM |
| 8 | MO | MM | OM | SS |
| 9 | MO | OO | OS | SM |
| 10 | MO | OO | OM | SS |
| 11 | MO | OS | OM | SS |
| 12 | MO | OS | OM | SM |
| 13 | MO | OS | SO | SM |
| 14 | MO | OS | SS | SM |
| 15 | MO | OM | SO | SS |
| 16 | MO | OM | SS | SM |
| 17 | MS | MM | OO | SS |
| 18 | MS | MM | OO | SM |
| 19 | MS | MM | OS | SO |
| 20 | MS | MM | OM | SO |
| 21 | MS | OO | OS | SM |
| 22 | MS | OO | OM | SO |
| 23 | MS | OO | OM | SM |
| 24 | MS | OO | SO | SM |
| 25 | MS | OO | SS | SM |
| 26 | MS | OS | OM | SO |
| 27 | MS | OM | SO | SS |
| 28 | MS | OM | SO | SM |
| 29 | MM | OO | OS | SO |
| 30 | MM | OO | OS | SS |
| 31 | MM | OO | OM | SS |
| 32 | MM | OO | SO | SS |
| 33 | MM | OO | SS | SM |
| 34 | MM | OS | OM | SO |
| 35 | MM | OS | SO | SS |
| 36 | MM | OS | SO | SM |

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **SILVONEN K.** *New Five-Standard Calibration Procedures for Network Analyzers and Wafer Probes,* 24. Juli 1998, ISBN 951-22-1989-1
- **SCHRAMM M. et al.** MOS-16: A New Method for In-Fixture Calibration and Fixture Characterization. *Proceeedings of the ARFTG,* Juni 2010

- **SILVONEN K.** LMR 16 - A Self-Calibration Procedure for a Leaky Network Analyzer. *IEEE Transactions on Microwave Theory and Techniques,* Juli 1997, vol. 45 (7), 1041-1049
- **YUN ZHANG ; KIMMO SILVONEN ; NING H ZHU.** Measurement of a reciprocal four-port transmission line structure using the 16-term error model. *Microwave and Optical Technology Letters,* 2007, vol. 49 (7), 1511-1515